# EUROPEAN PATENT SPECIFICATION

(11) **EP 4 394 887 B1**
(45) Date of publication and mention of the grant of the patent: **12.03.2025**
(21) Application number: 23217231.2
(22) Date of filing: 15.12.2023
(51) Int. Cl.: H01L 29/417, H01L 29/66, H01L 29/786, H01L 27/12

(54) **THIN FILM TRANSISTOR, METHOD FOR MANUFACTURING THE SAME AND DISPLAY APPARATUS COMPRISING THE SAME**
DÜNNSCHICHTTRANSISTOR, VERFAHREN ZU SEINER HERSTELLUNG UND ANZEIGEVORRICHTUNG DAMIT
TRANSISTOR À COUCHES MINCES, SON PROCÉDÉ DE FABRICATION ET APPAREIL D'AFFICHAGE LE COMPRENANT

(30) Priority: 28.12.2022 KR 20220187873
(43) Date of publication of application: 03.07.2024
(73) Proprietor: LG Display Co., Ltd., Seoul 07336 (KR)
(72) Inventor: Seul, Hyeonjoo, 10845 Gyeonggi-do (KR); Jung, Jinwon, 10845 Gyeonggi-do (KR); Choi, Sungju, 10845 Gyeonggi-do (KR); Park, Jaeyoon, 10845 GYEONGGI-DO (KR)
(74) Representative: Ter Meer Steinmeister & Partner

(56) References cited:
- US-A1- 2020 212 076
- US-A1- 2022 199 829
- US-A1- 2022 399 464

## Description

### BACKGROUND OF THE DICLOSURE

### Field of the Invention

The present disclosure relates to a thin film transistor, a method for manufacturing the same and a display apparatus comprising the same.

### Discussion of the Related Art

Transistors are widely used as switching devices or driving devices in the field of electronic apparatuses. In particular, because a thin film transistor can be manufactured on a glass substrate or a plastic substrate, the thin film transistor is widely used as a switching device of a display apparatus such as a liquid crystal display apparatus or an organic light emitting apparatus.

The thin film transistor can be categorized into an amorphous silicon thin film transistor in which amorphous silicon is used as an active layer, a polycrystalline silicon thin film transistor in which polycrystalline silicon is used as an active layer and an oxide semiconductor thin film transistor in which oxide semiconductor is used as an active layer, based on a material constituting the active layer.

Because amorphous silicon can be deposited in a short time to form an active layer, an amorphous silicon thin film transistor (a-Si TFT) has advantages in that a manufacturing process time is short and a production cost is low. On the other hand, the amorphous silicon thin film transistor has a drawback in that it is restrictively used for an active matrix organic light emitting diode (AMOLED) because a current driving capacity is not sufficient due to a low mobility and there is a change in a threshold voltage.

A polycrystalline silicon thin film transistor (poly-Si TFT) is made by depositing amorphous silicon and crystallizing the deposited amorphous silicon. The polycrystalline silicon thin film transistor has advantages in that the electron mobility is high, the stability is excellent, a thin profile and high resolution can be achieved and a power efficiency is high. Examples of the polycrystalline silicon thin film transistor include a low temperature poly silicon (LTPS) thin film transistor. However, because the process of manufacturing the polycrystalline silicon thin film transistor needs a step of crystallizing the amorphous silicon, a manufacturing cost is increased due to the increased number of the process steps, and crystallization is required at a high process temperature. When the polycrystalline silicon thin film transistor is applied to a large-sized display apparatus, it is difficult to ensure the uniformity of the thin film transistor due to the polycrystalline characteristics.

An oxide semiconductor thin film transistor, which has a high mobility and has a large resistance change in accordance with an oxygen content, has an advantage in that desired properties can be easily obtained. Further, because an oxide constituting an active layer can be grown at a relatively low temperature during a process of manufacturing the oxide semiconductor thin film transistor, the manufacturing cost of the oxide semiconductor thin film transistor is reduced. Furthermore, in view of the properties of the oxide, because an oxide semiconductor is transparent, it is favorable to embody a transparent display. US2022/199829 A1 discloses a thin film transistor known from the prior art.

In addition, when the oxide semiconductor thin film transistor is applied, a conductorization area needs to be formed for electrical connection between devices. When a channel portion of the oxide semiconductor layer is conductorized in the process of forming the conductorization area, it can be difficult to achieve a short-channel, and switching characteristics can be degraded due to a low threshold voltage. Therefore, studies for achieving a short-channel by using an oxide semiconductor thin film transistor and at the same time ensuring a threshold voltage of a certain level or more will be required.

### SUMMARY OF THE DISCLOSURE

The present disclosure has been made in view of the above problems and it is an object of the present disclosure to provide a thin film transistor that can minimize a conductorization permeation depth generated in a channel portion during a conductorization process.

It is another object of the present disclosure to provide a thin film transistor that that provides a short-channel, of which the channel length is short or small.

It is still another object of the present disclosure to provide a thin film transistor having a short-channel and a stable threshold voltage.

It is further still another object of the present disclosure to provide a method for manufacturing a thin film transistor.

It is further still another object of the present disclosure to provide a display apparatus including the above thin film transistor to have an excellent stability reliability, in which the thin film transistor is integrated.

In addition to the objects of the present disclosure as mentioned above, additional objects and features of the present disclosure will be clearly understood by those skilled in the art from the following description of the present disclosure.

The object is solved by the features of the independent claims. Preferred embodiments are given in the dependent claims.

In accordance with an aspect of the present disclosure, the above and other objects are achieved by providing a thin film transistor including an active layer including a channel portion, a first connection portion and a second connection portion; and a gate electrode at least partially overlapping the active layer, wherein the channel portion overlaps the gate electrode, the first connection portion contacts one side of the channel portion, the second connection portion contacts the other side of the channel portion, the active layer includes a first active layer, a second active layer on the first active layer, and a third active layer on the first active layer and the second active layer, the first active layer and the third active layer are in contact with each other in the channel portion, and the second active layer is disposed between the first active layer and the third active layer in the first connection portion and the second connection portion.

In another aspect a thin film transistor is provided, comprising an active layer including a channel, a first connection portion and a second connection portion contacting opposite sides of the channel; and a gate electrode overlapping the channel of the active layer, wherein the active layer includes: a first active layer; a second active layer on the first active layer in the first connection portion and the second connection portion of the active layer; and a third active layer contacting the first active layer in the channel and contacting the second active layer in the first connection portion and the second connection portion.

The second active layer can include a plurality of island-shaped patterns disposed to be spaced apart from each other.

The first active layer and the third active layer can contact each other in an entire area of the channel portion.

The first active layer and the third active layer may directly contact in the channel portion.

The first active layer and the third active layer can contact each other at a boundary between the channel portion and the first connection portion and a boundary between the channel portion and the second connection portion.

A thickness of the active layer can be reduced along a direction from the first connection portion toward the channel portion, preferably at a boundary between the channel portion and the first connection portion.

A thickness of the active layer can be increased along a direction from the channel portion toward the second connection portion, preferably at a boundary between the channel portion and the second connection portion.

The first active layer and the third active layer may not be in contact with each other in at least a portion of the channel portion.

The second active layer can be disposed between the first active layer and the third active layer at a boundary between the channel portion and the first connection portion.

The second active layer can be disposed between the first active layer and the third active layer at a boundary between the channel portion and the second connection portion.

The second active layer can have a mobility greater than a mobility of the first active layer.

The third active layer can have a mobility greater than a mobility of the first active layer.

The third active layer can have a mobility smaller than a mobility of the second active layer.

The first active layer can include at least one of an IGZO(InGaZnO)-based oxide semiconductor material, a GO(GaO)-based oxide semiconductor material, a GZO(GaZnO)-based oxide semiconductor material, an IGO(InGaO)-based oxide semiconductor material or a GZTO(GaZnSnO)-based oxide semiconductor material.

When the oxide semiconductor material included in the first active layer includes gallium (Ga) and indium (In), a concentration of gallium (Ga) may be higher than that of indium (In) based on the number of moles [Ga concentration > In concentration].

The second active layer can include at least one of an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based oxide semiconductor material, a ZnO-based oxide semiconductor material, a SIZO(SiInZnO)-based oxide semiconductor material, or a ZnON(Zn-Oxynitride)-based oxide semiconductor material.

When the oxide semiconductor material included in the second active layer includes gallium (Ga) and indium (In), a concentration of indium (In) may be higher than that of gallium (Ga) based on the number of moles [Ga concentration < In concentration].

The third active layer can include at least one of an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based oxide semiconductor material, a ZnO-based oxide semiconductor material, a SIZO(SiInZnO)-based oxide semiconductor material, or a ZnON(Zn-Oxynitride)-based oxide semiconductor material.

In accordance with another aspect of the present disclosure, the above and other objects can be accomplished by the provision of a display apparatus comprising the above thin film transistor.

In accordance with other aspect of the present disclosure, the above and other objects can be accomplished by the provision of a method for manufacturing a thin film transistor, which comprises forming an active layer on a substrate, forming a gate electrode that at least partially overlaps the active layer, and forming a first connection portion and a second connection portion by selectively conductorizing an area of the active layer, which does not overlap the gate electrode, wherein the forming an active layer includes forming a first active layer and a second active layer on the substrate, and forming a third active layer on the first active layer and the second active layer, an area of the active layer, which overlaps the gate electrode, becomes a channel portion by the selective conductorization, the first connection portion contacts one side of the channel portion, the second connection portion contacts the other side of the channel portion, the first active layer and the third active layer are in contact with each other in the channel portion, and the second active layer is disposed between the first active layer and the third active layer in the first connection portion and the second connection portion.

The second active layer can include a plurality of island-shaped patterns formed on the first active layer and disposed to be spaced apart from each other.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1A is a plan view illustrating a thin film transistor according to one embodiment of the present disclosure;
FIG. 1B is a cross-sectional view taken along line I-I' of FIG. 1A;
FIG. 2 is a cross-sectional view illustrating a thin film transistor according to another embodiment of the present disclosure;
FIG. 3A is a plan view illustrating a thin film transistor according to still another embodiment of the present disclosure;
FIG. 3B is a cross-sectional view taken along line II-II' of FIG. 3A;
FIG. 4A is a schematic view illustrating a conductorization permeation depth ΔL of a channel portion in a thin film transistor;
FIG. 4B is a schematic view illustrating resistivity of an active layer in the thin film transistor of FIG. 4A;
FIG. 5 is a graph illustrating characteristics of a threshold voltage depending on a channel length in the thin film transistor of FIG. 4A;
FIG. 6A is a schematic view illustrating a conductorization permeation depth ΔL of a channel portion in a thin film transistor according to one embodiment of the present disclosure;
FIG. 6B is a schematic view illustrating resistivity of an active layer in the thin film transistor of FIG. 6A;
FIG. 7 is a graph illustrating a threshold voltage of a thin film transistor depending on a channel length;
FIGS. 8A to 8E are schematic views illustrating a method for manufacturing a thin film transistor according to one embodiment of the present disclosure;
FIG. 9 is a schematic view illustrating a display apparatus according to another embodiment of the present disclosure;
FIG. 10 is a circuit diagram illustrating any one pixel of FIG. 9;
FIG. 11 is a plan view illustrating a pixel of FIG. 10;
FIG. 12 is a cross-sectional view taken along line III-III' of FIG. 11;
FIG. 13 is a circuit diagram illustrating any one pixel of a display apparatus according to still another embodiment of the present disclosure; and
FIG. 14 is a circuit diagram illustrating any one pixel of a display apparatus according to further still another embodiment of the present disclosure.

### DETAILED DESCRIPTION OF THE DISCLOSURE

Advantages and features of the present disclosure, and implementation methods thereof will be clarified through following embodiments described with reference to the accompanying drawings. The present disclosure can, however, be embodied in different forms and should not be construed as limited to the embodiments set forth herein. Rather, these embodiments are provided so that this disclosure will be thorough and complete, and will fully explain the present disclosure to those skilled in the art.

A shape, a size, a ratio, an angle, and a number disclosed in the drawings for describing embodiments of the present disclosure are merely an example, and thus, the present disclosure is not limited to the illustrated details. Like reference numerals refer to like elements throughout the specification.

In a case where 'comprise', 'have', and 'include' described in the present specification are used, another part can be added unless 'only~' is used. The terms of a singular form can include plural forms unless referred to the contrary.

In construing an element, the element is construed as including an error range although there is no explicit description. In describing a position relationship, for example, when the position relationship is described as 'upon~', 'above~', 'below~', and 'next to~', one or more portions can be arranged between two other portions unless 'just' or 'direct' is used.

Spatially relative terms such as "below," "beneath," "lower," "above," and "upper" can be used herein to easily describe a relationship of one element or elements to another element or elements as illustrated in the figures. It will be understood that these terms are intended to encompass different orientations of the device in addition to the orientation depicted in the figures. For example, if the device illustrated in the figure is reversed, the device described to be arranged "below," or "beneath" another device can be arranged "above" another device. Therefore, an exemplary term "below or beneath" can include "below or beneath" and "above" orientations. Likewise, an exemplary term "above" or "on" can include "above" and "below or beneath" orientations.

In describing a temporal relationship, for example, when the temporal order is described as "after," "subsequent," "next," and "before," a case which is not continuous can be included, unless "just" or "direct" is used. It will be understood that, although the terms "first," "second," etc. can be used herein to describe various elements, these elements should not be limited by these terms. These terms are only used to partition one element from another. For example, a first element could be termed a second element, and, similarly, a second element could be termed a first element, without departing from the scope of the present invention.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various embodiments of the present disclosure can be partially or overall coupled to or combined with each other, and can be variously inter-operated with each other and driven technically as those skilled in the art can sufficiently understand. The embodiments of the present can be performed independently from each other, or can be performed together in co-dependent relationship. In the drawings, the same or similar elements are denoted by the same reference numerals even though they are depicted in different drawings.

In the embodiments of the present disclosure, a source electrode and a drain electrode are distinguished from each other, for convenience of description. However, the source electrode and the drain electrode can be used interchangeably. The source electrode can be the drain electrode, and the drain electrode can be the source electrode. Also, the source electrode in any one embodiment of the present disclosure can be the drain electrode in another embodiment of the present disclosure, and the drain electrode in any one embodiment of the present disclosure can be the source electrode in another embodiment of the present disclosure.

In some embodiments of the present disclosure, for convenience of description, a source region is distinguished from a source electrode, and a drain region is distinguished from a drain electrode. However, the embodiments of the present disclosure are not limited to this structure. For example, a source region can be a source electrode, and a drain region can be a drain electrode. Also, a source region can be a drain electrode, and a drain region can be a source electrode. In addition, in some embodiments of the present disclosure, the term "channel" may mean "channel portion", and the term "channel portion" may mean "channel".

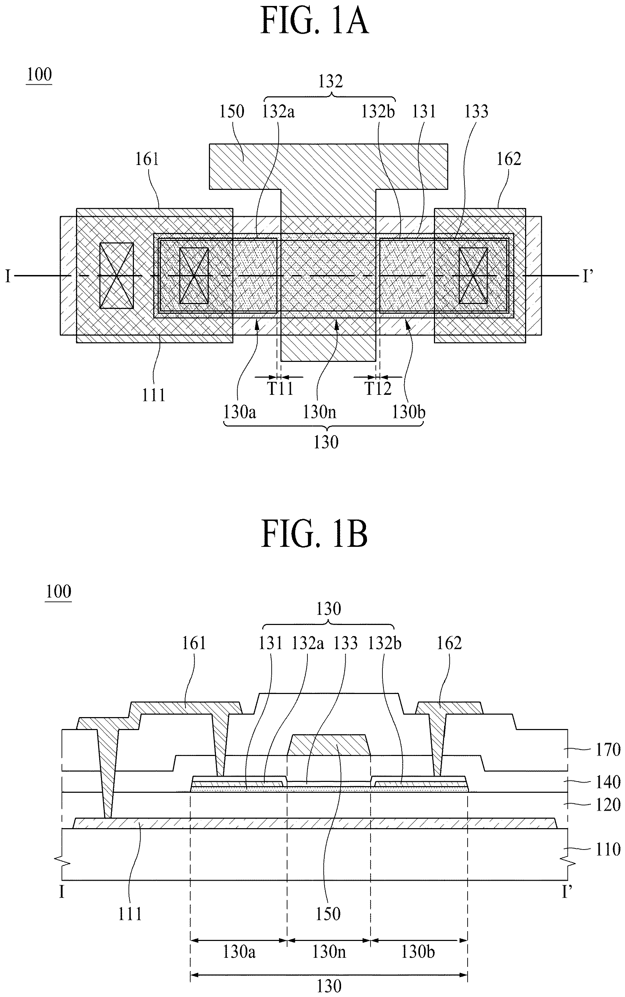

Hereinafter, a thin film transistor 100 according to one embodiment of the present disclosure will be described in more detail with reference to FIGS. 1A and 1B. In particular, FIG. 1A is a plan view illustrating a thin film transistor 100 according to one embodiment of the present disclosure, and FIG. 1B is a cross-sectional view taken along line I-I' of FIG. 1A. As shown, the thin film transistor 100 includes an active layer 130 and a gate electrode 150 that at least partially overlaps the active layer 130. The active layer 130 includes a first active layer 131, a second active layer 132 and a third active layer 133. Also, the active layer 130 includes a channel portion 130n, a first connection portion 130a that contacts one side of the channel portion 130n, and a second connection portion 130b that contacts the other side of the channel portion 130n. In an embodiment of the present disclosure, the "channel portion" can be referred to as "channel", and the "channel portion 130n" may be referred to as "channel 130n".

In other words, the first active layer 131 extends over the full length of the active layer 130 to be overlapped by the source and drain electrode 161, 162 respectively.

The second active layer 132 is only provided at the left and right portion, i.e. the first and second connection portion 130a, 130b of the active layer 130 to overlap the source and drain electrode 161, 162 respectively.

The gate electrode 150 overlaps the active layer 130 in the area of the channel portion 130n. The gate electrode 150 does not overlap the second active layer 132.

The third active layer 133 overlaps the second active layer 132 in the left and right portions of the active layer 130, i.e. the first and second connection portion 130a, 130b. The source and drain electrode 161, 162 are connected to the third active layer 133 in these areas respectively. In the area where the gate electrode 150 overlaps the channel portion130n, the third active layer 133 directly contacts the first active layer 131. Thus in the left and right portion the active layer is formed by the three sublayers, i.e. the first, second and third active layer, wherein the middle portion of the active layer 130 the active layer is only formed by the two sub layer, i.e. the first and the third active layer 131 and 133.

Referring to FIG. 1B, the thin film transistor 100 can be disposed on a substrate 110. A support for supporting the thin film transistor 100 can be referred to as the substrate 110 without limitation. Glass or plastic can be used as the substrate 110. A transparent plastic having a flexible property, for example, polyimide can be used as the plastic. When polyimide is used as the substrate 110, a heat-resistant polyimide capable of enduring a high temperature can be used considering that a high temperature deposition process is performed on the substrate 110.

Further, a light shielding layer 111 can be disposed on the substrate 110. As shown, the light shielding layer 111 overlaps at least the channel portion 130n of the active layer 130. The light shielding layer 111 thus shields light incident from the outside, thereby protecting the channel portion 130n. The light shielding layer 111 can be made of a material having light shielding characteristics. For example, the light shielding layer 111 can include at least one of an aluminum-based metal such as aluminum (Al) or an aluminum alloy, a molybdenum-based metal such as molybdenum (Mo) or a molybdenum alloy, chromium (Cr), tantalum (Ta), neodymium (Nd), titanium (Ti), or iron (Fe). The light shielding layer 111 can also be electrically connected to any one of a source electrode 161 and a drain electrode 162. The light shielding layer 111 can also be omitted.

In addition, a buffer layer 120 can be disposed on the light shielding layer 111 and can be made of an insulating material. For example, the buffer layer 120 can include at least one of silicon oxide, silicon nitride or metal-based oxide as an insulating material. The buffer layer 120 can also have a single-layered structure or a multi-layered structure. The buffer layer 120 can thus protect the active layer 130 by shielding the air and moisture. Also, the buffer layer 120 can planarize an upper portion of the substrate 110 on which the light shielding layer 111 is disposed.

Further, the active layer 130 is disposed on the buffer layer 120 and is formed by a semiconductor material. For example, the active layer 130 can be formed by an oxide semiconductor material. As shown, the active layer 130 includes a channel portion 130n, a first connection portion 130a and a second connection portion 130b. The channel portion 130n overlaps the gate electrode 150, and the channel portion 130n serves as a channel of the thin film transistor 100.

In addition, the first connection portion 130a and the second connection portion 130b are disposed at both sides of the channel portion 130n. The first connection portion 130a contacts one side of the channel portion 130n, and the second connection portion 130b contacts the other side of the channel portion 130n.

The first connection portion 130a and the second connection portion 130b can be formed by selective conductorization of a semiconductor material. In addition, providing conductivity to a selected portion of the active layer 130 will be referred to as selective conductorization. The selective conductorization can be performed by doping, plasma treatment or the like.

For example, selective conductorization for the active layer 130 can be performed by dopant doping using the gate electrode 150 or photoresist as a mask. In addition, implantation of dopant ions into a selected area of the active layer 130 will be referred to as dopant doping. The dopant can include at least one of, for example, boron (B), phosphorus (P), fluorine (F) or hydrogen (H).

When the selective conductorization for the active layer 130 is performed by dopant doping or implantation, an area doped with a dopant in the active layer 130 is selectively conductorized to become the first connection portion 130a or the second connection portion 130b. An area of the active layer 130, which is not doped with a dopant, is not conductorized, and becomes the channel portion 130n.

In addition, the selective conductorization for the active layer 130 can be performed by plasma treatment applied to a process of patterning a gate insulating layer 140. For example, plasma can be used in the process of patterning the gate insulating layer 140, and a portion of the active layer 130, which contacts the plasma, can be selectively conductorized to become the first connection portion 130a or the second connection portion 130b. A portion of the active layer 130, which is protected by the gate insulating layer 140 and does not contact the plasma, is not conductorized, and becomes the channel portion 130n.

In addition, the first connection portion 130a and the second connection portion 130b can be portions made of an oxide semiconductor material and then given conductivity. Therefore, the first connection portion 130a and the second connection portion 130b have a greater electrical conductivity than that of the channel portion 130n. By conductorization, the first connection portion 130a and the second connection portion 130b can have an electrical conductivity similar to that of a metal used as an electrical wiring.

A detailed structure of the first active layer 131, the second active layer 132 and the third active layer 133, which form a stacked structure of the active layer 130, will be described below. The gate insulating layer 140 is disposed on the active layer 130 and can include at least one of silicon oxide, silicon nitride or metal-based oxide. The gate insulating layer 140 can have a single-layer structure or a multi-layered structure. The gate insulating layer 140 also protects the channel portion 130n.

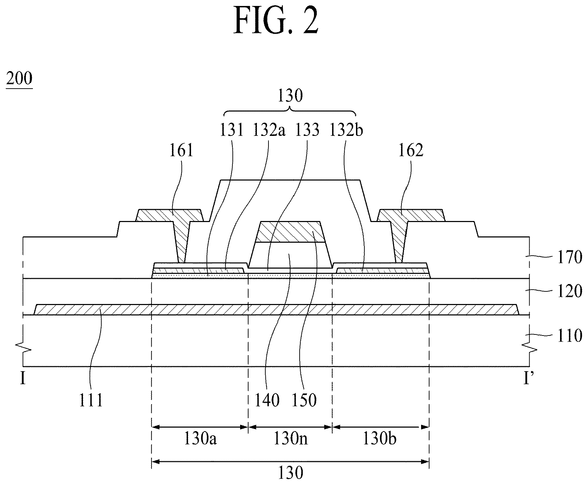

FIG. 1B illustrates a structure in which the gate insulating layer 140 covers the entire active layer 130 including the channel portion 130n, but the present disclosure is not limited thereto, and the gate insulating layer 140 can be patterned. For example, the gate insulating layer 140 can be patterned to cover only the channel portion 130n (see FIG. 2).

The gate electrode 150 is disposed on the gate insulating layer 140. The gate electrode 150 overlaps the channel portion 130n of the active layer 130. The gate electrode 150 can include at least one of an aluminum-based metal such as aluminum (Al) or an aluminum alloy, a silver-based metal such as silver (Ag) or a silver alloy, a copper-based metal such as copper (Cu) or a copper alloy, a molybdenum-based metal such as molybdenum (Mo) or a molybdenum alloy, chromium (Cr), tantalum (Ta), neodymium (Nd), or titanium (Ti). The gate electrode 150 can have a multi-layered structure that includes at least two conductive layers having their respective physical properties different from each other.

Referring to FIG. 1B, an interlayer insulating layer 170 is disposed on the gate electrode 150 and the gate insulating layer 140. The interlayer insulating layer 170 is an insulating layer made of an insulating material. The interlayer insulating layer 170 can be formed of an organic material, can be made of an inorganic material, or can be formed of a stacked body of an organic material layer and an inorganic material layer.

The source electrode 161 and the drain electrode 162 can be spaced apart from each other on the interlayer insulating layer 170. Each of the source electrode 161 and the drain electrode 162 can include at least one of molybdenum (Mo), aluminum (Al), chromium (Cr), gold (Au), titanium (Ti), nickel (Ni), neodymium (Nd), copper (Cu) or their alloy. Each of the source electrode 161 and the drain electrode 162 can be formed of a single layer made of a metal or a metal alloy, or can be formed of a multi-layer of two or more layers.

The source electrode 161 is connected to the active layer 130 through a contact hole that passes through the interlayer insulating layer 170 and the gate insulating layer 140. In more detail, the source electrode 161 can be electrically connected to the first connection portion 130a of the active layer 130 through the contact hole. In addition, the source electrode 161 can be connected to the light shielding layer 111 through the contact hole.

The drain electrode 162 is spaced apart from the source electrode 161, and is connected to the active layer 130 through the contact hole that passes through the interlayer insulating layer 170 and the gate insulating layer 140. In more detail, the drain electrode 162 can be electrically connected to the second connection portion 130b of the active layer 130 through the contact hole.

Hereinafter, the stacked structure of the active layer 130 according to one embodiment of the present disclosure will be described in more detail. Referring to FIG. 1B, the first active layer 131 can be disposed on the buffer layer 120.

Further, the first active layer 131 can be formed by an oxide semiconductor material. The first active layer 131 includes an oxide semiconductor material. The first active layer 131 can serve as a support layer for supporting the second active layer 132 and the third active layer 133, which are disposed thereon. Therefore, the first active layer 131 is also referred to as a "support layer," but one embodiment of the present disclosure is not limited thereto, and the first active layer 131 can serve as a channel layer.

Further, the first active layer 131 can include an oxide semiconductor material having excellent stability. The first active layer 131 can include at least one of, for example, a GO(GaO)-based oxide semiconductor material, a GZO(GaZnO)-based oxide semiconductor material, an IGO(InGaO)-based oxide semiconductor material, or a GZTO(GaZnSnO)-based oxide semiconductor material. When the oxide semiconductor material constituting the first active layer 131 includes gallium (Ga) and indium (In), a concentration of gallium (Ga) is set to be higher than that of indium (In) based on the number of moles [Ga concentration > In concentration]. The second active layer 132 is disposed on the first active layer 131.

Referring to FIGS. 1A and 1B, the second active layer 132 can include a plurality of patterns 132a and 132b. For example, the second active layer 132 can be patterned in an island shape. Further, the second active layer 132 can include a plurality of island-shaped patterns 132a and 132b spaced apart from each other.

Also, the second active layer 132 may not be disposed in the channel portion 130n. The second active layer 132 can be disposed in the first connection portion 130a and the second connection portion 130b so as to serve to lower contact resistance between the source electrode 161 and the active layer 130 and contact resistance between the drain electrode 162 and the active layer 130.

Also, the second active layer 132 cancan have a mobility greater than that of the first active layer 131. As a result, contact resistance between the active layer 130 and the source electrode 161 or between the active layer 130 and the drain electrode 162 can be lowered.

The second active layer 132 can be made of a material having high mobility and low resistance. For example, the second active layer 132 can include an oxide semiconductor material having high mobility characteristics. The second active layer can include at least one of, for example, an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based oxide semiconductor material, a ZnO-based oxide semiconductor material, a SIZO(SiInZnO)-based oxide semiconductor material, or a ZnON(Zn-Oxynitride)-based oxide semiconductor material. When the oxide semiconductor material constituting the second active layer 132 includes gallium (Ga) and indium (In), a concentration of indium (In) can be set to be higher than that of gallium (Ga) based on the number of moles [Ga concentration < In concentration].

Also, the second active layer 132 cancan have a mobility that is twice or greater than that of the first active layer 131. The second active layer 132 cancan have a mobility of 2 to 5 times as compared with the first active layer 131.

For example, the first active layer 131 can have a mobility of 5cm²/V·s to 25cm²/V·s. In more detail, the first active layer 131 can have a mobility of 5cm²/V·s to 15cm²N·s, or can have a mobility of about 10 cm²/V·s. The second active layer 132 can have a mobility of 20cm²/V·s or more. In more detail, the second active layer 132 can have a mobility of 20cm²/V·s to 50cm²/V·s. In more detail, the second active layer 132 can have a mobility in the range of 20cm²/V·s to 40cm²/V·s or 20cm²/V·s to 30cm²/V·s.

In addition, the second active layer 132 can have a mobility greater than that of the first active layer 131 as much as 10cm²/V·s to 40cm²/V·s. The second active layer 132 can have a mobility greater than that of the first active layer 131 as much as 10cm²/V·s to 30 cm²/V·s, 10cm²/V·s to 20cm²/V·s, or 20cm²/V·s to 30cm²/V·s.

In addition, because the second active layer 132 includes an oxide semiconductor material, adhesion stability and interface stability can be improved between the first active layer 131 and the second active layer 132 and between the third active layer 133 and the second active layer 132, which are made of an oxide semiconductor material. As a result, interface characteristics between the first active layer 131 and the second active layer 132 and between the third active layer 133 and the second active layer 132 can be improved, whereby the physical and chemical stability of the active layer 130 can be improved. Therefore, the stability of the thin film transistor 100 can be improved.

Also, because the second active layer 132 has an excellent mobility and low resistance characteristics, the first connection portion 130a and the second connection portion 130b can actively function as wirings by the second active layer 132.

Also, the third active layer 133 is disposed on the first active layer 131 and the second active layer 132. In addition, a main channel of the thin film transistor 100 can be formed in the third active layer 133. Therefore, the third active layer 133 can serve as a channel layer, but the present disclosure is not limited thereto, and the third active layer 133 can serve to protect an upper portion of the active layer 130.

In addition, the third active layer 133 can include at least one of an IGZO(InGaZnO)-based oxide semiconductor material, a GO(GaO)-based oxide semiconductor material, a GZO(GaZnO)-based oxide semiconductor material, an IGO(InGaO)-based oxide semiconductor material, a ZnO-based oxide semiconductor material, a ZnNO-based oxide semiconductor material, an IGZTO(InGaZnSnO)-based oxide semiconductor material, a GZTO (GaZnSnO)-based oxide semiconductor material, an IZO(InZnO)-based oxide semiconductor material, an ITZO(InSnZnO)-based oxide semiconductor material, a FIZO(FeInZnO)-based oxide semiconductor material, a SIZO(SiInZnO)-based oxide semiconductor material, or a ZnON(Zn-Oxynitride)-based oxide semiconductor material.

When the third active layer 133 serves as a main channel layer, the third active layer 133 can include at least one of an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based oxide semiconductor material, ZnO-based oxide semiconductor material, a SIZO(SiInZnO)-based oxide semiconductor material, or a ZnON(Zn-Oxynitride)-based oxide semiconductor material. When the oxide semiconductor material constituting the third active layer 133 designed to serve as a main channel layer includes gallium (Ga) and indium (In), a concentration of indium (In) can be set to be higher than that of gallium (Ga) based on the number of moles [Ga concentration < In concentration].

When the third active layer 133 serves to protect the upper portion of the active layer 130, the third active layer 133 can include at least one of an IGZO(InGaZnO)-based oxide semiconductor material, a GO(GaO)-based oxide semiconductor material, a GZO(GaZnO)-based oxide semiconductor material, an IGO(InGaO)-based oxide semiconductor material or a GZTO(GaZnSnO)-based oxide semiconductor material. When the oxide semiconductor material constituting the third active layer 133 designed to serve as a protective layer includes gallium (Ga) and indium (In), the concentration of gallium (Ga) can be set to be higher than the concentration of indium (In) based on the number of moles [Ga concentration > In concentration].

In addition, the third active layer 133 mainly serves as a main channel layer. Therefore, the characteristics of the thin film transistor 100 according to one embodiment of the present disclosure can be changed depending on the mobility or electrical characteristics of the third active layer 133.

When the thin film transistor 100 is a transistor having a high mobility, the third active layer 133 can include at least one of an IGZO(InGaZnO)-based oxide semiconductor material, an IZO(InZnO)-based oxide semiconductor material, an ITZO(InSnZnO)-based oxide semiconductor material, an IGZTO(InGaZnSnO)-based oxide semiconductor material, a FIZO(FeInZnO)-based oxide semiconductor material, ZnO-based oxide semiconductor material, a SIZO(SiInZnO)-based oxide semiconductor material, or a ZnON(Zn-Oxynitride)-based oxide semiconductor material. In this instance, when the oxide semiconductor material constituting the third active layer 133 includes gallium (Ga) and indium (In), the concentration of indium (In) can be set to be higher than that of gallium (Ga) based on the number of moles [Ga concentration < In concentration]. The active layer 130 of the thin film transistor 100 having high mobility characteristics cancan have a mobility of, for example, 40 cm²/V·s or more.

When the thin film transistor 100 is a transistor having low mobility characteristics, the third active layer 133 can include at least one of an IGZO(InGaZnO)-based oxide semiconductor material, a GO(GaO)-based oxide semiconductor material, a GZO(GaZnO)-based oxide semiconductor material, an IGO(InGaO)-based oxide semiconductor material or a GZTO(GaZnSnO)-based oxide semiconductor material. In this instance, when the oxide semiconductor material constituting the third active layer 133 includes gallium (Ga) and indium (In), a concentration of gallium Ga can be set to be higher than that of indium (In) based on the number of moles [Ga concentration > In concentration]. The active layer 130 of the thin film transistor 100 having low mobility characteristics can have a mobility of, for example, 10 cm²/V·s.

In addition, as shown in FIG. 1B, the first active layer 131 and the third active layer 133 contact each other in the channel portion 130n. In addition, the second active layer 132 can be disposed between the first active layer 131 and the third active layer 133 in the first connection portion 130a and the second connection portion 130b.

Referring to FIG. 1B, an upper surface of the first active layer 131 and a lower surface of the third active layer 133 contact each other in the channel portion 130n. In this instance, the upper surface of the first active layer 131 can be defined as a surface directed toward the gate electrode 150, and the lower surface of the third active layer 133 can be defined as a surface opposite to the gate electrode 150. Alternatively, an upper surface of each layer can be defined as a surface directed toward an opposite side of the substrate 110, and a lower surface of each layer can be defined as a surface directed toward the substrate 110.

In addition, the third active layer 133 can have a mobility greater than that of the first active layer 131. As a result, the third active layer 133 can serve as a main channel layer of the thin film transistor 100. In this instance, the first active layer 131 can serve as a support layer. Also, the third active layer 133 can have a mobility smaller than that of the second active layer 132. Therefore, the thin film transistor 100 can be prevented from having an excessively low threshold voltage, and can have a large threshold voltage.

In addition, as the second active layer 132 is made of an oxide semiconductor material, the second active layer 132 can have an excellent adhesion stability to the first active layer 131 and the third active layer 133, which are made of an oxide semiconductor material. As a result, the interface characteristics between the first active layer 131 and the second active layer 132 and between the third active layer 133 and the second active layer 132 are improved so that the physical and chemical stability of the active layer 130 can be improved. In addition, as the second active layer 132 has a mobility greater than that of the third active layer 133, the electrical conductivity of the first connection portion 130a and the second connection portion 130b is improved by the second active layer 132, so that a wiring function of the first connection portion 130a and the second connection portion 130b can be improved.

In addition, the first active layer 131 and the third active layer 133 can contact each other in the entire area of the channel portion 130n. In this instance, as shown in FIGS. 1A and 1B, the second active layer 132 is not disposed in the channel portion 130n.

Referring to FIGS. 1A and 1B, the first active layer 131 and the third active layer 133 can contact each other at a boundary between the channel portion 130n and the first connection portion 130a and a boundary between the channel portion 130n and the second connection portion 130b. In this instance, the channel portion 130n includes a first active layer 131 and a third active layer 133.

Referring to FIG. 1B, a thickness of the channel portion 130n is thin as compared with a thickness of the first connection portion 130a and the second connection portion 130b. In general, a material movement and diffusion from a thick portion to a thin portion is not easy. As a result, a conductorization permeation depth ΔL of the channel portion 130n formed in the conductorization process of the first connection portion 130a and the second connection portion 130b can be reduced.

For example, when the first connection portion 130a and the second connection portion 130b are conductorized by dopant doping, the first connection portion 130a and the second connection portion 130b are doped and dopants doped in the first connection portion 130a and the second connection portion 130b are diffused into the channel portion 130n so that a conductorization permeation phenomenon can occur at the edge of the channel portion 130n. When the active layer 130 becomes rapidly thin at the boundary between the first connection portion 130a and the channel portion 130n and the boundary between the second connection portion 130b and the channel portion 130n, the diffusion efficiency of the dopant toward the channel portion 130n is lowered. As a result, the conductorization permeation depth ΔL of the channel portion 130n can be reduced.

Also, when the first connection portion 130a and the second connection portion 130b are conductorized by plasma treatment, the gate insulating layer 140 at the same level as the upper surface of the first connection portion 130a and the second connection portion 130b is directly affected by the plasma treatment. On the other hand, because the channel portion 130n is positioned lower than the upper surface of the first connection portion 130a and the second connection portion 130b due to its thin thickness, the channel portion 130n is not directly affected by the plasma. Therefore, the conductorization permeation depth ΔL of the channel portion 130n can be reduced.

Additionally, the conductorization permeation depth ΔL in the channel portion 130n is affected even by an increase in diffusion of hydrogen (H) or occurrence of oxygen vacancy (Vo). Because the channel portion 130n is mainly formed by the first active layer 131 and the third active layer 133, the channel portion 130n has an excellent stability and reliability. Therefore, hydrogen (H) is not easily diffused into the channel portion 130n, and occurrence of oxygen vacancy (Vo) in the channel portion 130n is not easily increased or diffused. As a result, a conductorization permeation phenomenon in the channel portion 130n is suppressed, so that a short conductorization permeation depth ΔL can be formed.

Further, as shown in FIGS. 1A and 1B, the second active layer 132 can be spaced apart from the channel portion 130n without being disposed in the channel portion 130n. In particular, the second active layer 132 and the channel portion 130n can be spaced apart from each other at predetermined spaced distances T11 and T12. Further, the distances T11 and T12 between the second active layer 132 and the channel portion 130n can be set in the range that a thickness of the channel portion 130n is rapidly reduced near the boundary between the channel portion 130n and the first connection portion 130a and the boundary between the channel portion 130n and the second connection portion 130b. For example, the distances T11 and T12 between the second active layer 132 and the channel portion 130n can be set to 1µm or less. In more detail, the distances T11 and T12 between the second active layer 132 and the channel portion 130n can be in the range of 0.5µm to 1µm.

Referring to FIG. 1B, the thickness of the active layer 130 is greatly changed near the boundary between the channel portion 130n and the first connection portion 130a and the boundary between the channel portion 130n and the second connection portion 130b. In more detail, the thickness of the active layer 130 can be reduced along a direction from the first connection portion 130a toward the channel portion 130n centered on the boundary between the channel portion 130n and the first connection portion 130a. Also, the thickness of the active layer 130 can be increased along a direction from the channel portion 130n toward the second connection portion 130b centered on the boundary between the channel portion 130n and the second connection portion 130b.

In the thin film transistor 100 according to one embodiment of the present disclosure, the thickness of the channel portion 130n is rapidly reduced near the boundary between the channel portion 130n and the first connection portion 130a and the boundary between the channel portion 130n and the second connection portion 130b, and the conductorization permeation depth ΔL of the channel portion 130n is very small. As a result, the resistivity is rapidly increased near the boundary between the channel portion 130n and the first connection portion 130a and the boundary between the channel portion 130n and the second connection portion 130b. Therefore, even though the thin film transistor 100 has a short channel length, an effective channel length can be obtained, and the thin film transistor 100 can have excellent switching characteristics. According to one embodiment of the present disclosure, a short-channel means a channel having short channel length.

Next, FIG. 2 is a cross-sectional view illustrating a thin film transistor 200 according to another embodiment of the present disclosure. Referring to FIG. 2, the gate insulating layer 140 can be patterned without being formed on the entire surface of the substrate 110. For example, as shown in FIG. 2, the gate insulating layer 140 can be patterned in a planar shape corresponding to the gate electrode 150.

In addition, the light shielding layer 111 may not be connected to the source electrode 161. The light shielding layer 111 can be connected to the drain electrode 162, or can be connected to the gate electrode 150. The light shielding layer 111 can also be omitted.

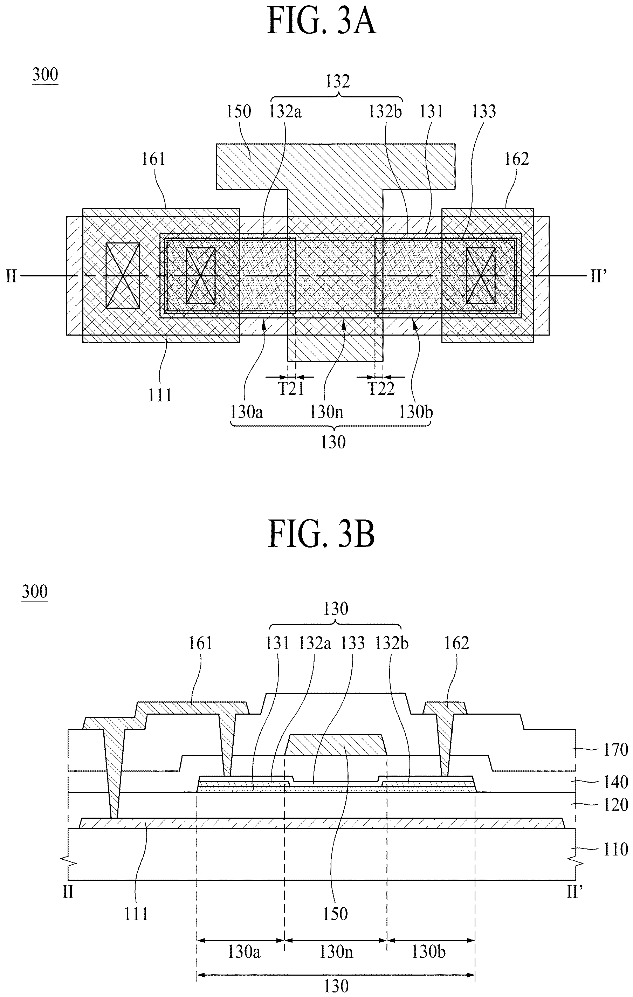

Next, FIG. 3A is a plan view illustrating a thin film transistor 300 according to still another embodiment of the present disclosure, and FIG. 3B is a cross-sectional view taken along line II-II' of FIG. 3A. Hereinafter, in order to avoid redundancy, the description of the already described elements will be omitted.

Referring to FIGS. 3A and 3B, the first active layer 131 and the third active layer 133 do not contact each other in at least a portion of the channel portion 130n. Further, the second active layer 132 can be disposed between the first active layer 131 and the third active layer 133 at the boundary between the channel portion 130n and the first connection portion 130a. In addition, the second active layer 132 can be disposed between the first active layer 131 and the third active layer 133 at the boundary between the channel portion 130n and the second connection portion 130b.

As shown in FIGS. 3A and 3B, even though the second active layer 132 is disposed between the first active layer 131 and the third active layer 133 at the boundary between the channel portion 130n and the first connection portion 130a or between the channel portion 130n and the second connection portion 130b, the thickness of the channel portion 130n can be rapidly reduced near the boundary between the channel portion 130n and the first connection portion 130a and the boundary between the channel portion 130n and the second connection portion 130b. As a result, the resistivity is rapidly increased near the boundary between the channel portion 130n and the first connection portion 130a and the boundary between the channel portion 130n and the second connection portion 130b. Therefore, even though the thin film transistor 100 has a short channel length, an effective channel length can be obtained, and the thin film transistor 300 can have excellent switching characteristics.

According to another embodiment of the present disclosure, as shown in FIGS. 3A and 3B, the second active layer 132 can be disposed to overlap the channel portion 130n. In particular, the second active layer 132 can overlap the channel portion 130n as much as predetermined overlap lengths T21 and T22 from the boundary between the channel portion 130n and the first connection portion 130a or the boundary between the channel portion 130n and the second connection portion 130b. An overlap length of the second active layer 132 and the channel portion 130n can be set to be shorter than the conductorization permeation depth ΔL of the channel portion.

For example, to rapidly reduce the thickness of the channel portion 130n near the boundary between the channel portion 130n and the first connection portion 130a and the boundary between the channel portion 130n and the second connection portion 130b, the overlap lengths T21 and T22 of the second active layer 132 and the channel portion 130n can be set to 1µm or less. In more detail, the overlap lengths T21 and T22 of the second active layer 132 and the channel portion 130n can be in the range of 0.5µm to 1µm. In this instance, the overlap lengths T21 and T22 of the second active layer 132 and the channel portion 130n is the shortest distance between the first connection portion 130a and the second connection portion 130b.

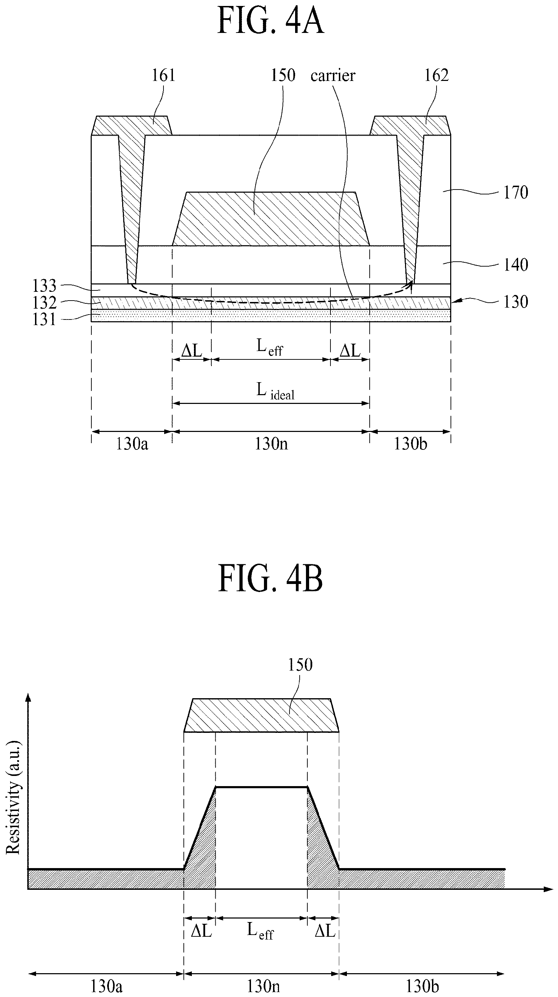

Next, FIG. 4A is a schematic view illustrating a conductorization permeation depth ΔL of a channel portion 130n in a thin film transistor. In the process of forming the active layer 130 of the thin film transistor, an area designed as the channel portion 130n can be partially conductorized so that a portion, which cannot serve as a channel, can be generated. Further, the portion of the area designed as the channel portion 130n, which is conductorized so as not to serve as a channel, has a length that is referred to as a conductorization permeation depth ΔL.

Referring to FIG. 4A, a length of the channel portion 130n of the active layer 130, which is overlapped with the gate electrode 150, is represented by "L_{ideal}." "L_{ideal}" in FIG. 4A can be referred to as an ideal length of the channel portion 130n. In FIG. 4A, a moving path of a carrier indicated by "carrier" is exemplarily illustrated.

A portion of the area designed as the channel portion 130n can be unnecessarily conductorized during the selective conductorization process for the active layer 130, and the conductorized area does not serve as a channel. In FIG. 4A, a conductorization permeation depth, which is the length of the conductorized portion of the channel portion 130n, is represented by "ΔL." Also, the length of the area of the channel portion 130n, which is not conductorized and can effectively serve as a channel, is referred to as an effective channel length L_{eff}. When the conductorization permeation depth ΔL is increased, the effective channel length Leff becomes smaller.

The thin film transistor preferably has an effective channel length L_{eff} of a predetermined length or more in order to perform required functions. However, when the conductorization permeation depth ΔL is increased, the length of the channel portion 130n or a design length of the channel portion 130n should be increased to ensure the effective channel length L_{eff}. In this way, when the length of the channel portion 130n is increased, it is difficult to miniaturize and integrate the device.

Next, FIG. 4B is a schematic view illustrating a resistivity of an active layer in the thin film transistor of FIG. 4A. Referring to FIG. 4B, as the thin film transistor of FIG. 4A has a relatively large conductorization permeation depth ΔL, a resistivity is gently changed at the boundary between the channel portion 130n and the first connection portion 130a and the boundary between the channel portion 130n and the second connection portion 130b. As a result, an effective channel length L_{eff}, which is the length of an area capable of effectively serving as a channel in the channel portion 130n, is reduced as much as the conductorization permeation depth ΔL.

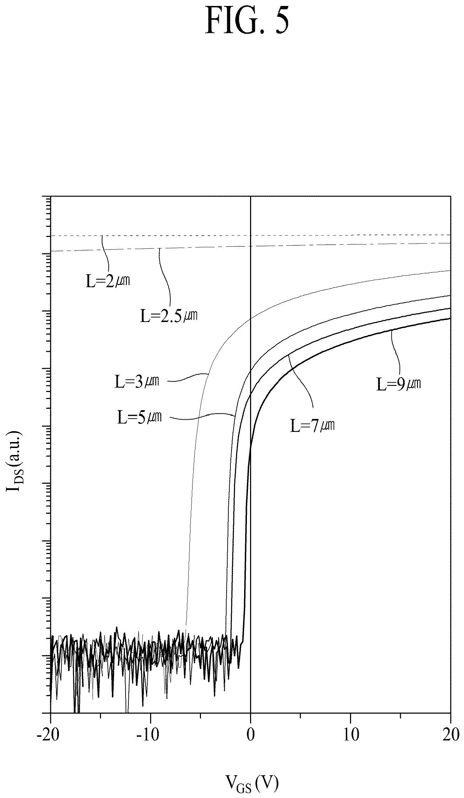

Next, FIG. 5 is a graph illustrating characteristics of a threshold voltage depending on a channel length L in the thin film transistor of FIG. 4A. Referring to FIG. 5, in the thin film transistor of FIG. 4A, the thin film transistor does not have a threshold voltage when the channel length L becomes reduced. In more detail, in FIG. 5, when the channel length L is 9 µm, 7 µm and 5 µm, the thin film transistor can effectively have a threshold voltage. When the channel length L is 3 µm, the threshold voltage of the thin film transistor is very unstable. When the channel length L is 2.5 µm or 2 µm, the thin film transistor does not have a threshold voltage.

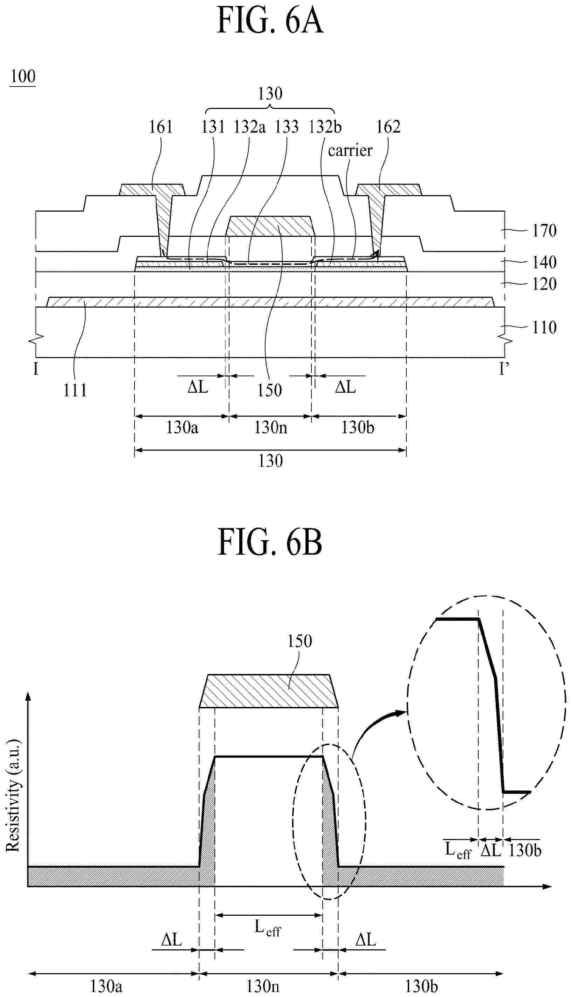

FIG. 6A is a schematic view illustrating a conductorization permeation depth ΔL of a channel portion in a thin film transistor 100 according to one embodiment of the present disclosure. Referring to FIG. 6A, a carrier can mainly move along the third active layer 133.

As already described, in FIG. 6A, in the thin film transistor 100 according to one embodiment of the present disclosure, the thickness of the channel portion 130n is rapidly reduced near the boundary between the channel portion 130n and the first connection portion 130a and the boundary between the channel portion 130n and the second connection portion 130b. Therefore, the conductorization permeation depth ΔL of the channel portion 130n is very small, and the resistivity is rapidly increased near the boundary between the channel portion 130n and the first connection portion 130a and the boundary between the channel portion 130n and the second connection portion 130b. As a result, even though the thin film transistor 100 has a short channel length, an effective channel length can be obtained.

FIG. 6B is a schematic view illustrating the resistivity of an active layer in the thin film transistor of FIG. 6A. As the thin film transistor 100 of FIG. 6A has a very small conductorization permeation depth ΔL, the resistivity is rapidly changed at the boundary between the channel portion 130n and the first connection portion 130a and the boundary between the channel portion 130n and the second connection portion 130b. As a result, a length of the channel portion 130n, which is lost due to the conductorization permeation depth ΔL, is reduced, so that an effective channel length L_{eff} can be effectively obtained.

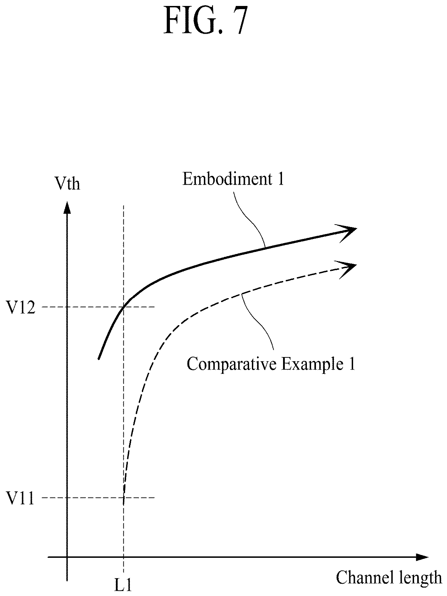

Next, FIG. 7 is a graph illustrating a threshold voltage of a thin film transistor depending on a channel length. In FIG. 7, "Embodiment 1" denotes the thin film transistor 100 having the structure shown in FIG. 6A, and "Comparative Example 1" denotes the thin film transistor having the structure shown in FIG. 4A.

Referring to FIG. 7, the Embodiment 1, which is the thin film transistor 100 having the structure shown in FIG. 6A, can have an effective threshold voltage V12 when the channel length is L1, and can have an effective threshold voltage even though the channel length is smaller than L1. On the other hand, the Comparative Example 1, which is the thin film transistor having the structure shown in FIG. 4A, can have a threshold voltage V11, which is a very low threshold voltage, when the channel length is L1, and cannot have an effective threshold voltage when the channel length is smaller than L1.

As described above, the thin film transistor according to one embodiment of the present disclosure can have a threshold voltage even though the channel length is short, and can also have a relatively high threshold voltage as compared with the Comparative Example 1 and thus can have a short channel, of which the channel length is short. In this way, according to the embodiments of the present disclosure, it is advantageous to design a thin film transistor having a short-channel.

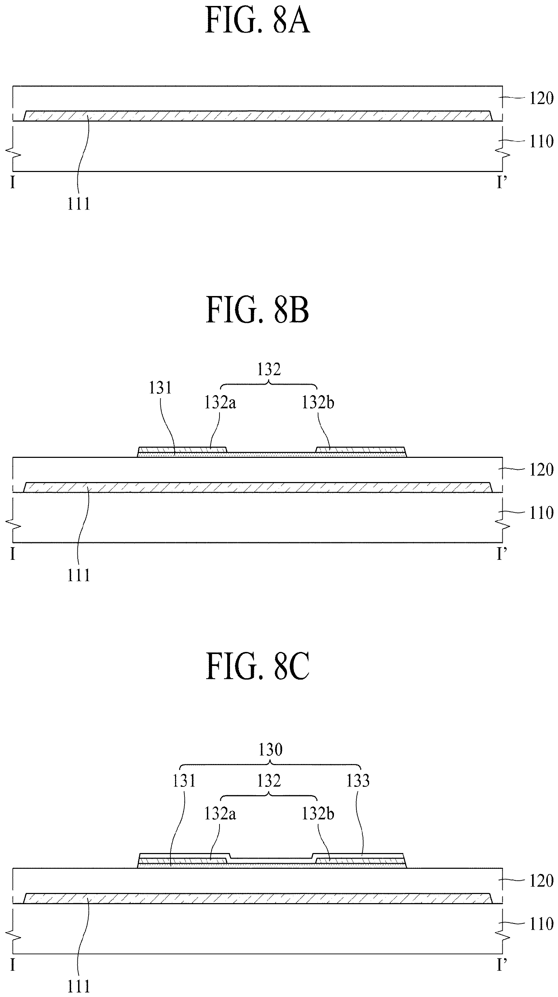

Hereinafter, a method for manufacturing a thin film transistor 100 according to one embodiment of the present disclosure will be described below with reference to FIGS. 8A to 8E. In particular, FIGS. 8A to 8E are schematic views illustrating a method for manufacturing a thin film transistor 100 according to one embodiment of the present disclosure.

Referring to FIG. 8A, a light shielding layer 111 is formed on a substrate 110, and a buffer layer 120 is formed on the light shielding layer 111. Further, an active layer 130 is formed on the substrate 110.

In more detail, referring to FIG. 8B, a first active layer 131 and a second active layer 132 are formed on the buffer layer 120. The first active layer 131 and the second active layer 132 can be made of an oxide semiconductor material. The second active layer 132 is formed on the first active layer 131 and patterned in an island shape. For example, the second active layer 132 can include a plurality of island-shaped patterns 132a and 132b spaced apart from each other.

Referring to FIG. 8C, a third active layer 133 is formed on the first active layer 131 and the second active layer 132. The third active layer 133 can be disposed to overlap and contact the first active layer 131 and the second active layer 132 so that the active layer 130 can be formed.

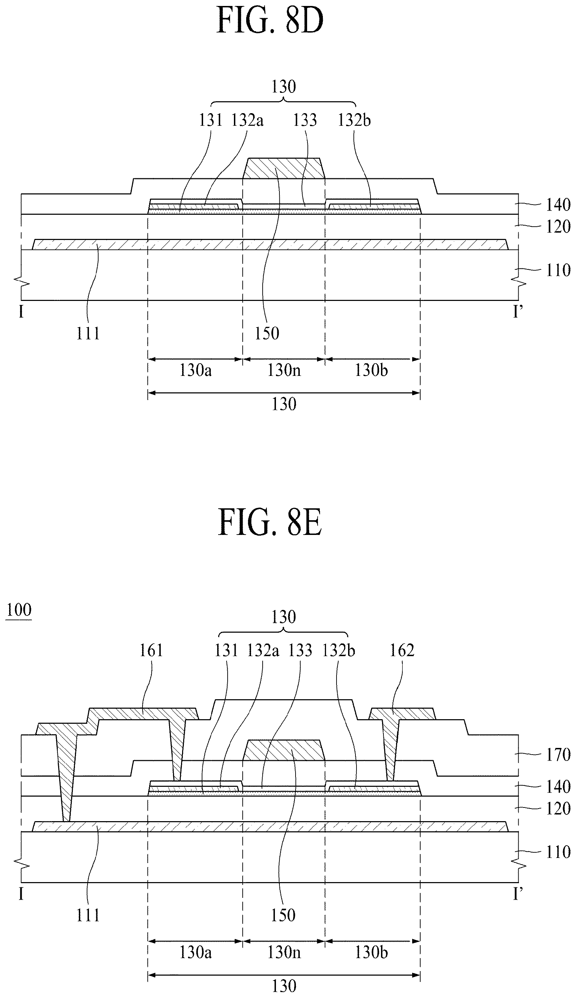

Referring to FIG. 8D, a gate electrode 150 at least partially overlapping the active layer 130 is formed on the active layer 130. In more detail, a gate insulating layer 140 is formed on the active layer 130, and a gate electrode 150 is formed on the gate insulating layer 140. The gate electrode 150 at least partially overlaps the active layer 130. In more detail, the gate electrode 150 overlaps a channel portion 130n.

Next, the active layer 130 is selectively conductorized. In more detail, an area of the active layer 130, which does not overlap the gate electrode 150, is selectively conductorized by selective conductorization using the gate electrode 150 as a mask. As a result, a first connection portion 130a and a second connection portion 130b are formed.

The area of the active layer 130, which overlaps the gate electrode 150, becomes the channel portion 130n by the selective conductorization. The first connection portion 130a contacts one side of the channel portion 130n, and the second connection portion 130b contacts the other side of the channel portion 130n.

The first active layer 131 and the third active layer 133 contact each other in the channel portion 130n. In addition, the second active layer 132 is disposed between the first active layer 131 and the third active layer 133 in the first connection portion 130a and the second connection portion 130b.

Referring to FIG. 8E, an interlayer insulating layer 170 is formed on the gate electrode 150 and the gate insulating layer 140. Contact holes are formed in the interlayer insulating layer 170. Also, a source electrode 161 and a drain electrode 162 are formed on the interlayer insulating layer 170. The source electrode 161 is connected to the first connection portion 130a of the active layer 130 through the contact hole. In addition, the drain electrode 162 is connected to the second connection portion 130b of the active layer 130 through the contact hole. As a result, the thin film transistor 100 according to one embodiment of the present disclosure can be made.

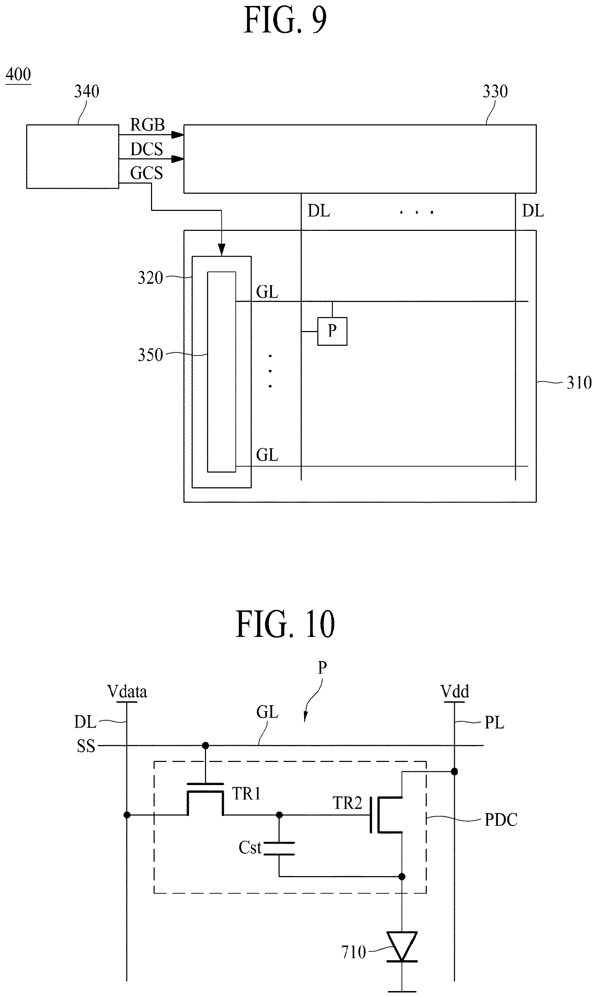

Hereinafter, the display apparatus including the above-described thin film transistors 100, 200 and 300 will be described In more detail. FIG. 9 is a schematic view illustrating a display apparatus 400 according to another embodiment of the present disclosure.

As shown in FIG. 9, the display apparatus 400 includes a display panel 310, a gate driver 320, a data driver 330 and a controller 340. Gate lines GL and data lines DL are disposed in the display panel 310, and pixels P are disposed in intersection areas of the gate lines GL and the data lines DL. An image is displayed by driving of the pixels P.

The controller 340 controls the gate driver 320 and the data driver 330. The controller 340 also outputs a gate control signal GCS for controlling the gate driver 320 and a data control signal DCS for controlling the data driver 330 by using a signal supplied from an external system. Also, the controller 340 samples input image data input from the external system, realigns the sampled data and supplies the realigned digital image data RGB to the data driver 330.

The gate control signal GCS includes a gate start pulse GSP, a gate shift clock GSC, a gate output enable signal GOE, a start signal Vst and a gate clock GCLK. Also, control signals for controlling a shift register can be included in the gate control signal GCS. The data control signal DCS includes a source start pulse SSP, a source shift clock signal SSC, a source output enable signal SOE and a polarity control signal POL.

The data driver 330 supplies a data voltage to the data lines DL of the display panel 310. In more detail, the data driver 330 converts the image data RGB input from the controller 340 into an analog data voltage and supplies the data voltage to the data lines DL. The gate driver 320 can include a shift register 350.

The shift register 350 sequentially supplies gate pulses to the gate lines GL for one frame by using the start signal and the gate clock, which are transmitted from the controller 340. In this instance, one frame means a time period at which one image is output through the display panel 310. The gate pulse has a turn-on voltage capable of turning on a switching device (thin film transistor) disposed in the pixel P.

Also, the shift register 350 supplies a gate-off signal capable of turning off the switching device, to the gate line GL for the other period of one frame, at which the gate pulse is not supplied. Hereinafter, the gate pulse and the gate-off signal will be collectively referred to as a scan signal SS or Scan.

Further, the gate driver 320 can be packaged on the substrate 110. In this way, a structure in which the gate driver 320 is directly packaged on the substrate 110 will be referred to as a Gate In Panel (GIP) structure.

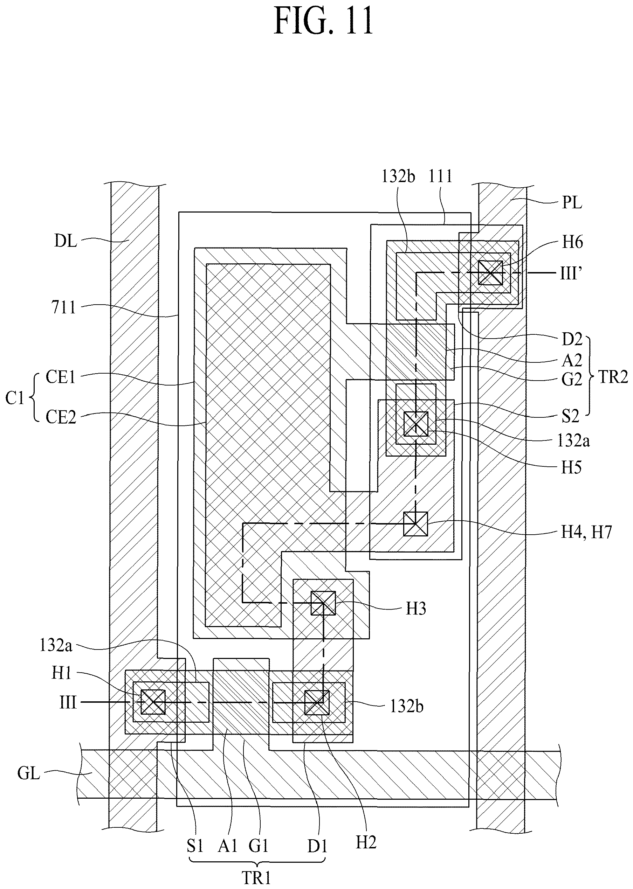

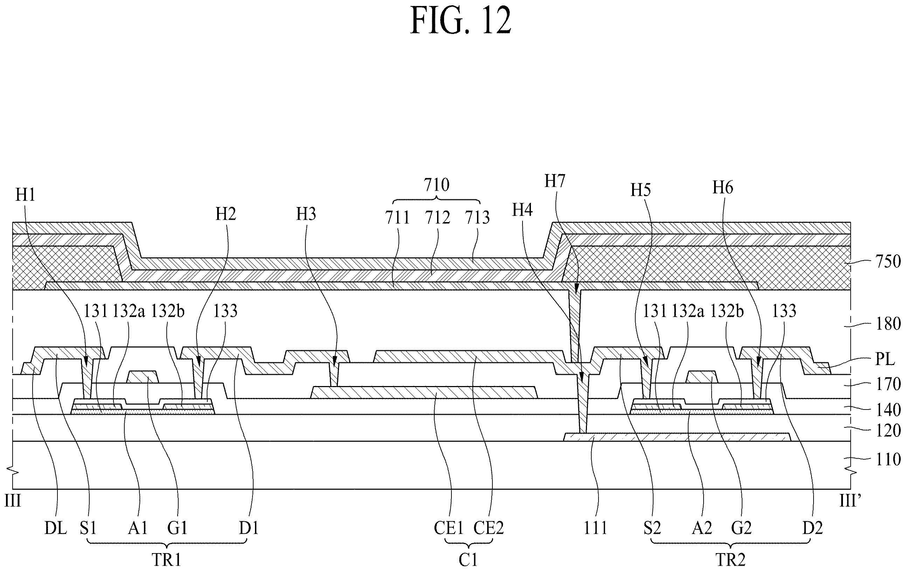

Next, FIG. 10 is a circuit diagram illustrating any one pixel P of FIG. 9, FIG. 11 is a plan view illustrating a pixel P of FIG. 10, and FIG. 12 is a cross-sectional view taken along line III-III' of FIG. 11. The circuit diagram of FIG. 10 is an equivalent circuit diagram for the pixel P of the display apparatus 400 that includes an organic light emitting diode (OLED) as a display device 710.

The pixel P includes a display device 710 and a pixel driving circuit PDC for driving the display device 710. The pixel driving circuit PDC of FIG. 10 includes a first thin film transistor TR1 that is a switching transistor and a second thin film transistor TR2 that is a driving transistor. For example, one of the above-described thin film transistors 100, 200 and 300 can be used as the first thin film transistor TR1 and the second thin film transistor TR2.

The first thin film transistor TR1 is connected to the gate line GL and the data line DL, and is turned on or off by the scan signal SS supplied through the gate line GL. In addition, the data line DL provides a data voltage Vdata to the pixel driving circuit PDC, and the first thin film transistor TR1 controls applying of the data voltage Vdata.

A driving power line PL provides a driving voltage Vdd to the display device 710, and the second thin film transistor TR2 controls the driving voltage Vdd. The driving voltage Vdd is a pixel driving voltage for driving the organic light emitting diode (OLED) that is the display device 710. When the first thin film transistor TR1 is turned on by the scan signal SS applied from the gate driver 320 through the gate line GL, the data voltage Vdata supplied through the data line DL is supplied to a gate electrode G2 of the second thin film transistor TR2 connected with the display device 710. The data voltage Vdata is charged in a storage capacitor Cst formed between the gate electrode G2 and a source electrode S2 of the second thin film transistor TR2.

The amount of a current supplied to the organic light emitting diode (OLED), which is the display device 710, through the second thin film transistor TR2 is controlled in accordance with the data voltage Vdata, whereby a gray scale of light emitted from the display device 710 can be controlled.

Referring to FIGS. 11 and 12, the first thin film transistor TR1 and the second thin film transistor TR2 are disposed on the substrate 110. The substrate 110 can be made of glass or plastic. Plastic having a flexible property, for example, polyimide (PI) can be used as the substrate 110.

The light shielding layer 111 is disposed on the substrate 110 and has light shielding characteristics. The light shielding layer 111 can thus protect the active layer A2 by shielding light incident from the outside. A buffer layer 120 is disposed on the light shielding layer 111. In addition, the buffer layer 120 is made of an insulating material, and protects active layers A1 and A2 from external moisture or oxygen.

The active layer A1 of the first thin film transistor TR1 and the active layer A2 of the second thin film transistor TR2 are disposed on the buffer layer 120. The active layers A1 and A2 can include, for example, an oxide semiconductor material and can have a multi-layered structure made of an oxide semiconductor material.

For example, the active layers A1 and A2 can include a first active layer 131, second active layer 132 and a third active layer 133. The second active layer 132 is disposed between the first active layer 131 and the third active layer 133. Also, the first active layer 131 and the third active layer 133 contact each other in a channel portion.

A gate insulating layer 140 is disposed on the active layers A1 and A2. The gate insulating layer 140 covers upper surfaces of the active layers A1 and A2. In addition, the gate electrode G1 of the first thin film transistor TR1 and the gate electrode G2 of the second thin film transistor TR2 are disposed on the gate insulating layer 140. Also, the gate line GL is disposed on the gate insulating layer 140. The gate electrode G1 of the first thin film transistor TR1 can also be extended from the gate line GL, or can be a portion of the gate line GL.

Referring to FIG. 12, a first capacitor electrode CE1 is formed on the gate insulating layer 140. The first capacitor electrode CE1 can be formed of the same material as that of the gate electrodes G1 and G2 by the same process as that of the gate electrodes G1 and G2. An interlayer insulating layer 170 is also disposed on the gate electrodes G1 and G2, the gate line GL and the first capacitor electrode CE1.

In addition, the data line DL and the driving power line PL are disposed on the interlayer insulating layer 170. Also, the source electrode S1 and the drain electrode D1 of the first thin film transistor TR1 and the source electrode S2 and the drain electrode D2 of the second thin film transistor TR2 are disposed on the interlayer insulating layer 170.

The source electrode S1 of the first thin film transistor TR1 can be formed integrally with the data line DL, and can have a structure extended from the data line DL. The source electrode S1 of the first thin film transistor TR1 can contact the active layer A1 of the first thin film transistor TR1 through a first contact hole H1.

Further, the drain electrode D1 of the first thin film transistor TR1 can contact the active layer A1 of the first thin film transistor TR1 through a second contact hole H2. Also, the drain electrode D1 of the first thin film transistor TR1 is connected to the first capacitor electrode CE1 through a third contact hole H3. As a result, the first capacitor electrode CE1 can be connected to the first thin film transistor TR1.

In addition, the drain electrode D2 of the second thin film transistor TR2 can be formed integrally with the driving power line PL, and have a structure extended from the driving power line PL. The drain electrode D2 of the second thin film transistor TR2 can also contact the active layer A2 of the second thin film transistor TR2 through a sixth contact hole H6.

Further, the source electrode S2 of the second thin film transistor TR2 can contact the active layer A2 of the second thin film transistor TR2 through a fifth contact hole H5. Also, the source electrode S2 of the second thin film transistor TR2 is connected to the light shielding layer 111 through a fourth contact hole H4. The same voltage as that of the source electrode S2 of the second thin film transistor TR2 can be applied to the light shielding layer 111 that overlaps the second thin film transistor TR2. In addition, the source electrode S2 of the second thin film transistor TR2 can be extended onto the interlayer insulating layer 170 to form a second capacitor electrode CE2. Also, the first capacitor electrode CE1 and the second capacitor electrode CE2 overlap each other to form the first capacitor C1. The first capacitor C1 is a storage capacitor Cst.

Referring to FIG. 12, a planarization layer 180 is disposed on the data line DL, the driving power line PL, the source electrodes S1 and S2, the drain electrodes D1 and D2 and the second capacitor electrode CE2. The planarization layer 180 planarizes upper portions of the first thin film transistor TR1 and the second thin film transistor TR2 and protects the first thin film transistor TR1 and the second thin film transistor TR2. The planarization layer 180 thus serves as a protective layer.

In addition, a first electrode 711 of the display device 710 is disposed on the planarization layer 180. The first electrode 711 of the display device 710 can contact the second capacitor electrode CE2 through a seventh contact hole H7 formed in the planarization layer 180. As a result, the first electrode 711 of the display device 710 can be connected to the source electrode S2 of the second thin film transistor TR2.

Also, a bank layer 750 is disposed at an edge of the first electrode 711 and defines a light emission area of the display device 710. An organic light emitting layer 712 is disposed on the first electrode 711, and a second electrode 713 is disposed on the organic light emitting layer 712. Therefore, the display device 710 is completed. The display device 710 shown in FIG. 12 is an organic light emitting diode (OLED). Therefore, the display apparatus 400 according to one embodiment of the present disclosure is an organic light emitting display apparatus.

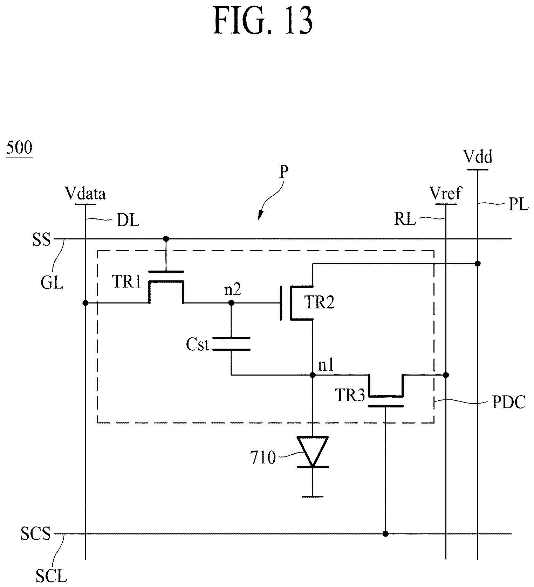

Next, FIG. 13 is a circuit diagram illustrating any one pixel P of a display apparatus 500 according to still another embodiment of the present disclosure. In particular, FIG. 13 is an equivalent circuit diagram illustrating a pixel P of an organic light emitting display apparatus.

The pixel P of the display apparatus 500 shown in FIG. 13 includes an organic light emitting diode (OLED) that is a display device 710 and a pixel driving circuit PDC for driving the display device 710. The display device 710 is connected with the pixel driving circuit PDC. In the pixel P, signal lines DL, GL, PL, RL and SCL for supplying a signal to the pixel driving circuit PDC are disposed.

The data voltage Vdata is supplied to the data line DL, the scan signal SS is supplied to the gate line GL, the driving voltage Vdd for driving the pixel is supplied to the driving power line PL, a reference voltage Vref is supplied to a reference line RL, and a sensing control signal SCS is supplied to a sensing control line SCL. Also, the gate line GL can serve as the sensing control line SCL.

The pixel driving circuit PDC includes, for example, a first thin film transistor TR1 (switching transistor) connected with the gate line GL and the data line DL, a second thin film transistor TR2 (driving transistor) for controlling a magnitude of a current output to the display device 710 in accordance with the data voltage Vdata transmitted through the first thin film transistor TR1, and a third thin film transistor TR3 (sensing transistor) for sensing characteristics of the second thin film transistor TR2.

A storage capacitor Cst is positioned between the gate electrode G2 of the second thin film transistor TR2 and the display device 710. The first thin film transistor TR1 is turned on by the scan signal SS supplied to the gate line GL to transmit the data voltage Vdata, which is supplied to the data line DL, to the gate electrode G2 of the second thin film transistor TR2.

In addition, the third thin film transistor TR3 is connected between a first node n1 between the second thin film transistor TR2 and the display device 710 and the reference line RL, and thus is turned on or off by the sensing control signal SCS and senses characteristics of the second thin film transistor TR2, which is a driving transistor, for a sensing period. A second node n2 connected with the gate electrode G2 of the second thin film transistor TR2 is connected with the first thin film transistor TR1. The storage capacitor Cst is formed between the second node n2 and the first node n1.

When the first thin film transistor TR1 is turned on, the data voltage Vdata supplied through the data line DL is supplied to the gate electrode G2 of the second thin film transistor TR2. The data voltage Vdata is charged in the storage capacitor Cst formed between the gate electrode G2 and the source electrode S2 of the second thin film transistor TR2.

When the second thin film transistor TR2 is turned on, the current is supplied to the display device 710 through the second thin film transistor TR2 in accordance with the driving voltage Vdd for driving the pixel, whereby light is output from the display device 710.

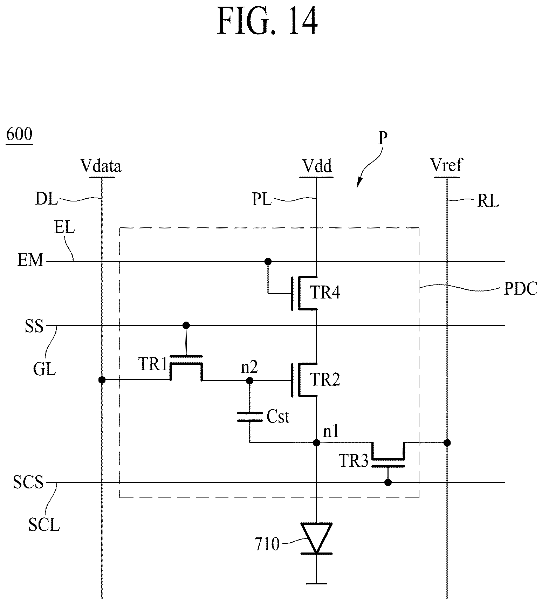

Next, FIG. 14 is a circuit diagram illustrating any one pixel of a display apparatus 600 according to further still another embodiment of the present disclosure. The pixel P of the display apparatus 600 shown in FIG. 14 includes an organic light emitting diode (OLED) that is a display device 710 and a pixel driving circuit PDC for driving the display device 710. The display device 710 is connected with the pixel driving circuit PDC. The pixel driving circuit PDC includes thin film transistors TR1, TR2, TR3 and TR4. In the pixel P, signal lines DL, EL, GL, PL, SCL and RL for supplying a driving signal to the pixel driving circuit PDC are disposed.

In comparison with the pixel P of FIG. 13, the pixel P of FIG. 14 further includes an emission control line EL. An emission control signal EM is supplied to the emission control line EL. Also, the pixel driving circuit PDC of FIG. 14 further includes a fourth thin film transistor TR4 that is an emission control transistor for controlling a light emission timing of the second thin film transistor TR2, in comparison with the pixel driving circuit PDC of FIG. 13. The gate line GL can serve as the sensing control line SCL.

The storage capacitor Cst is positioned between the gate electrode G2 of the second thin film transistor TR2 and the display device 710. The first thin film transistor TR1 is turned on by the scan signal SS supplied to the gate line GL to transmit the data voltage Vdata, which is supplied to the data line DL, to the gate electrode G2 of the second thin film transistor TR2. The third thin film transistor TR3 is connected to the reference line RL, and thus is turned on or off by the sensing control signal SCS and senses characteristics of the second thin film transistor TR2, which is a driving transistor, for a sensing period.

The fourth thin film transistor TR4 transfers the driving voltage Vdd to the second thin film transistor TR2 in accordance with the emission control signal EM, or shields the driving voltage Vdd. When the fourth thin film transistor TR4 is turned on, a current is supplied to the second thin film transistor TR2, whereby light is output from the display device 710.

The pixel driving circuit PDC according to further still another embodiment of the present disclosure can be formed in various structures in addition to the above-described structure. The pixel driving circuit PDC can include, for example, five or more thin film transistors.

According to the present disclosure, the following advantageous effects can be obtained. In particular, the first active layer, the second active layer, and the third active layer are disposed in the connection portion, but the first active layer and the third active layer are disposed in the channel portion, so that the conductorization permeation depth generated in the channel portion can be reduced. As a result, the thin film transistor can have a short-channel. In addition, the thin film transistor can have a stable threshold voltage Vth while having a short-channel.

Because the thin film transistor has a stable threshold voltage, the display apparatus according to one embodiment of the present disclosure, which includes the thin film transistor, can have an excellent reliability. **In** addition, because the thin film transistor can have a short-channel, the thin film transistor can be disposed to be integrated at high density in the display apparatus.

It will be apparent to those skilled in the art that the present disclosure described above is not limited by the above-described embodiments and the accompanying drawings and that various substitutions, modifications and variations can be made in the present disclosure without departing from the scope of the disclosures.

## Claims

1. A thin film transistor (100) comprising:
an active layer (130) including a channel portion (130n), a first connection portion (130a) and a second connection portion (130b) contacting opposite sides of the channel portion (130n); and
a gate electrode (150) overlapping the channel portion (130n) of the active layer (130), wherein the active layer (130) includes:
a first active layer (131);
a second active layer (132) on the first active layer (131) in the first connection portion (130a) and the second connection portion (130b) of the active layer (130); and
a third active layer (133) contacting the first active layer (131) in the channel portion (130n) and contacting the second active layer (132) in the first connection portion (130a) and the second connection portion (130b).

2. The thin film transistor of claim 1, wherein the second active layer (132) includes a plurality of spaced apart island-shaped patterns (132a, 132b.

3. The thin film transistor of claim 1 or 2, wherein the first active layer (131) and the third active layer (133) contact each other in an area of the channel portion (130n) or the first active layer (131) and the third active layer (133) contact each other at a first boundary between the channel portion (130n) and the first connection portion (130a) and at a second boundary between the channel and the second connection portion (130b).

4. The thin film transistor of any one of the preceding claims, wherein a thickness of the active layer (130) is reduced along a direction from the first connection portion (130a) toward the channel portion (130n) preferably at a boundary between the channel portion (130n) and the first connection portion (130a) and/or a thickness of the active layer (130) is increased along a direction from the channel portion (130n) toward the second connection portion (130b), , preferably at a boundary between the channel portion (130n) and the second connection portion (130a).

5. The thin film transistor of any one of the preceding claims, wherein the first active layer (131) and the third active layer (133) do not contact each other in at least a portion of the channel.

6. The thin film transistor of claim 5, wherein the second active layer (132) is disposed between the first active layer (131) and the third active layer (133) at a first boundary between the channel portion (130n) and the first connection portion (130a) and/or the second active layer (132) is disposed between the first active layer (131) and the third active layer (133) at a second boundary between the channel portion (130n) and the second connection portion (130b).

7. The thin film transistor of any one of the preceding claims, wherein the second active layer (132) has a mobility greater than a mobility of the first active layer (131) and/or the third active layer (133) has a mobility greater than a mobility of the first active layer (131) and/or the third active layer (133) has a mobility smaller than a mobility of the second active layer (132).

8. The thin film transistor of any one of the preceding claims, wherein the first active layer (131) includes at least one of an IGZO (InGaZnO)-based oxide semiconductor material, a GO (GaO)-based oxide semiconductor material, a GZO (GaZnO)-based oxide semiconductor material, an IGO (InGaO)-based oxide semiconductor material or a GZTO (GaZnSnO)-based oxide semiconductor material, and/or when the oxide semiconductor material included in the first active layer (131) includes gallium (Ga) and indium (In), a concentration of gallium (Ga) is higher than that of indium (In) based on the number of moles [Ga concentration > In concentration].

9. The thin film transistor of any one of the preceding claims, wherein the second active layer (132) includes at least one of an IGZO (InGaZnO)-based oxide semiconductor material, an IZO (InZnO)-based oxide semiconductor material, an ITZO (InSnZnO)-based oxide semiconductor material, an IGZTO (InGaZnSnO)-based oxide semiconductor material, a FIZO (FeInZnO)-based oxide semiconductor material, a ZnO-based oxide semiconductor material, a SIZO (SiInZnO)-based oxide semiconductor material, or a ZnON (Zn-Oxynitride)-based oxide semiconductor material, and/or when the oxide semiconductor material included in the second active layer includes gallium (Ga) and indium (In), a concentration of indium (In) is higher than that of gallium (Ga) based on the number of moles [Ga concentration < In concentration].

10. The thin film transistor of any one of the preceding claims, wherein the third active layer (133) includes at least one of an IGZO (InGaZnO)-based oxide semiconductor material, an IZO (InZnO)-based oxide semiconductor material, an ITZO (InSnZnO)-based oxide semiconductor material, an IGZTO (InGaZnSnO)-based oxide semiconductor material, a FIZO (FeInZnO)-based oxide semiconductor material, a ZnO-based oxide semiconductor material, a SIZO (SiInZnO)-based oxide semiconductor material, or a ZnON (Zn-Oxynitride)-based oxide semiconductor material, and/or when the oxide semiconductor material included in the third active layer includes gallium (Ga) and indium (In), a concentration of indium (In) is higher than that of gallium (Ga) based on the number of moles [Ga concentration < In concentration].

11. The thin film transistor of any one of the preceding claims 1-9, wherein the third active layer (133) includes at least one of an IGZO (InGaZnO)-based oxide semiconductor material, a GO (GaO)-based oxide semiconductor material, a GZO (GaZnO)-based oxide semiconductor material, an IGO (InGaO)-based oxide semiconductor material or a GZTO (GaZnSnO)-based oxide semiconductor material, and/or when the oxide semiconductor material included in the third active layer includes gallium (Ga) and indium (In), a concentration of gallium (Ga) is higher than that of indium (In) based on the number of moles [Ga concentration > In concentration].

12. The thin film transistor of any one of the preceding claims, wherein at least one or both of the gate electrodes (G1, G2) comprise tapered edges tapering in a first direction, and /or the second active layer (132) comprises tapered edges tapering in a second direction opposite to the first direction.

13. The thin film transistor of any one of the preceding claims, further comprising:
a buffer layer (120) on a substrate (110); and
a gate insulation layer (140) on the third active layer (133) and the buffer layer (120).

14. A display apparatus comprising the thin film transistor of any one of the preceding claims.

15. A method for manufacturing a thin film transistor, the method comprising:
forming an active layer (130) on a substrate (110);
forming a gate electrode (150) at least partially overlapping the active layer (130); and
forming a first connection portion (130a) and a second connection portion (130b) by selectively conductorizing areas of the active layer (130) not overlapping the gate electrode (150) to form a channel portion (130n) by the selective conductorization, wherein the forming the active layer (130) includes:
forming a first active layer (131) on the substrate (110);
forming a second active layer (132) on the first active layer (131) in the first connection portion (130a) and the second connection portion (130b) of the active layer (130); and
forming a third active layer (133) contacting the first active layer (131) in the channel portion (130n) and contacting the second active layer (132) in the first connection portion (130a) and the second connection portion (130b).

## Patentansprüche

1. Dünnschichttransistor (100), der Folgendes umfasst:
eine aktive Schicht (130), die einen Kanalabschnitt (130n), einen ersten Verbindungsabschnitt (130a) und einen zweiten Verbindungsabschnitt (130b), die gegenüberliegende Seiten des Kanalabschnitts (130n) kontaktieren, enthält; und
eine Gate-Elektrode (150), die den Kanalabschnitt (130n) der aktiven Schicht (130) überdeckt, wobei die aktive Schicht (130) Folgendes enthält:
eine erste aktive Schicht (131);
eine zweite aktive Schicht (132) auf der ersten aktiven Schicht (131) in dem ersten Verbindungsabschnitt (130a) und dem zweiten Verbindungsabschnitt (130b) der aktiven Schicht (130); und
eine dritte aktive Schicht (133), die die erste aktive Schicht (131) in dem Kanalabschnitt (130n) kontaktiert und die zweite aktive Schicht (132) in dem ersten Verbindungsabschnitt (130a) und dem zweiten Verbindungsabschnitt (130b) kontaktiert.

2. Dünnschichttransistor nach Anspruch 1, wobei die zweite aktive Schicht (132) mehrere voneinander beabstandete inselförmige Muster (132a, 132b) enthält.

3. Dünnschichttransistor nach Anspruch 1 oder 2, wobei die erste aktive Schicht (131) und die dritte aktive Schicht (133) in einem Bereich des Kanalabschnitts (130n) miteinander in Kontakt sind oder die erste aktive Schicht (131) und die dritte aktive Schicht (133) an einer ersten Grenze zwischen dem Kanalabschnitt (130n) und dem ersten Verbindungsabschnitt (130a) und an einer zweiten Grenze zwischen dem Kanalabschnitt (130n) und dem zweiten Verbindungsabschnitt (130b) miteinander in Kontakt sind.

4. Dünnschichttransistor nach einem der vorhergehenden Ansprüche, wobei eine Dicke der aktiven Schicht (130) in einer Richtung von dem ersten Verbindungsabschnitt (130a) zu dem Kanalabschnitt (130n), vorzugsweise an einer Grenze zwischen dem Kanalabschnitt (130n) und dem ersten Verbindungsabschnitt (130a), abnimmt und/oder eine Dicke der aktiven Schicht (130) in einer Richtung von dem Kanalabschnitt (130n) zu dem zweiten Verbindungsabschnitt (130b), vorzugsweise an einer Grenze zwischen dem Kanalabschnitt (130n) und dem zweiten Verbindungsabschnitt (130b), zunimmt.

5. Dünnschichttransistor nach einem der vorhergehenden Ansprüche, wobei die erste aktive Schicht (131) und die dritte aktive Schicht (133) zumindest einem Abschnitt des Kanals nicht miteinander in Kontakt sind.

6. Dünnschichttransistor nach Anspruch 5, wobei die zweite aktive Schicht (132) zwischen der ersten aktiven Schicht (131) und der dritten aktiven Schicht (133) an einer ersten Grenze zwischen dem Kanalabschnitt (130n) und dem ersten Verbindungsabschnitt (130a) angeordnet ist und/oder die zweite aktive Schicht (132) zwischen der ersten aktiven Schicht (131) und der dritten aktiven Schicht (133) an einer zweiten Grenze zwischen dem Kanalabschnitt (130n) und dem zweiten Verbindungsabschnitt (130b) angeordnet ist.

7. Dünnschichttransistor nach einem der vorhergehenden Ansprüche, wobei die zweite aktive Schicht (132) eine Mobilität aufweist, die größer ist als eine Mobilität der ersten aktiven Schicht (131), und/oder die dritte aktive Schicht (133) eine Mobilität aufweist, die größer ist als eine Mobilität der ersten aktiven Schicht (131), und/oder die dritte aktive Schicht (133) eine Mobilität aufweist, die kleiner ist als eine Mobilität der zweiten aktiven Schicht (132).

8. Dünnschichttransistor nach einem der vorhergehenden Ansprüche, wobei die erste aktive Schicht (131) ein IGZO-basiertes (InGaZnO-basiertes) Oxid-Halbleitermaterial und/oder ein GO-basiertes (GaO-basiertes) Oxid-Halbleitermaterial und/oder ein GZO-basiertes (GaZnO-basiertes) Oxid-Halbleitermaterial und/oder ein IGO-basiertes (InGaO-basiertes) Oxid-Halbleitermaterial und/oder ein GZTO-basiertes (GaZnSnO-basiertes) Oxid-Halbleitermaterial enthält und/oder wobei dann, wenn das Oxid-Halbleitermaterial, das in der ersten aktiven Schicht (131) enthalten ist, Gallium (Ga) und Indium (In) enthält, eine Konzentration von Gallium (Ga) basierend auf der Molzahl höher ist als jene von Indium (In) [Ga-Konzentration > In-Konzentration].

9. Dünnschichttransistor nach einem der vorhergehenden Ansprüche, wobei die zweite aktive Schicht (132) ein IGZO-basiertes (InGaZnO-basiertes) Oxid-Halbleitermaterial und/oder ein IZO-basiertes (InZnO-basiertes) Oxid-Halbleitermaterial und/oder ein ITZObasiertes (InSnZnO-basiertes) Oxid-Halbleitermaterial und/oder ein IGZTO-basiertes (InGaZnSnO-basiertes) Oxid-Halbleitermaterial und/oder ein FIZO-basiertes (FeInZnObasiertes) Oxid-Halbleitermaterial und/oder ein ZnO-basiertes Oxid-Halbleitermaterial und/oder ein SIZO-basiertes (SiInZnO-basiertes) Oxid-Halbleitermaterial und/oder ein ZnON-basiertes (Zn-Oxinitrid-basiertes) Oxid-Halbleitermaterial enthält und/oder wobei dann, wenn das Oxid-Halbleitermaterial, das in der zweiten aktiven Schicht enthalten ist, Gallium (Ga) und Indium (In) enthält, eine Konzentration von Indium (In) basierend auf der Molzahl höher ist als jene von Gallium (Ga) [Ga-Konzentration < In-Konzentration].

10. Dünnschichttransistor nach einem der vorhergehenden Ansprüche, wobei die dritte aktive Schicht (133) ein IGZO-basiertes (InGaZnO-basiertes) Oxid-Halbleitermaterial und/oder ein IZO-basiertes (InZnO-basiertes) Oxid-Halbleitermaterial und/oder ein ITZObasiertes (InSnZnO-basiertes) Oxid-Halbleitermaterial und/oder ein IGZTO-basiertes (InGaZnSnO-basiertes) Oxid-Halbleitermaterial und/oder ein FIZO-basiertes (FeInZnObasiertes) Oxid-Halbleitermaterial und/oder ein ZnO-basiertes Oxid-Halbleitermaterial und/oder ein SIZO-basiertes (SiInZnO-basiertes) Oxid-Halbleitermaterial und/oder ein ZnON-basiertes (Zn-Oxinitrid-basiertes) Oxid-Halbleitermaterial enthält und/oder wobei dann, wenn das Oxid-Halbleitermaterial, das in der dritten aktiven Schicht enthalten ist, Gallium (Ga) und Indium (In) enthält, eine Konzentration von Indium (In) basierend auf der Molzahl höher ist als jene von Gallium (Ga) [Ga-Konzentration < In-Konzentration].

11. Dünnschichttransistor nach einem der vorhergehenden Ansprüche 1-9, wobei die dritte aktive Schicht (133) ein IGZO-basiertes (InGaZnO-basiertes) Oxid-Halbleitermaterial und/oder ein GO-basiertes (GaO-basiertes) Oxid-Halbleitermaterial und/oder ein GZO-basiertes (GaZnO-basiertes) Oxid-Halbleitermaterial und/oder ein IGO-basiertes (InGaO-basiertes) Oxid-Halbleitermaterial und/oder ein GZTO-basiertes (GaZnSnO-basiertes) Oxid-Halbleitermaterial enthält und/oder wobei dann, wenn das Oxid-Halbleitermaterial, das in der dritten aktiven Schicht enthalten ist, Gallium (Ga) und Indium (In) enthält, eine Konzentration von Gallium (Ga) basierend auf der Molzahl höher ist als jene von Indium (In) [Ga-Konzentration > In-Konzentration].

12. Dünnschichttransistor nach einem der vorhergehenden Ansprüche, wobei mindestens eine oder beide der Gate-Elektroden (G1, G2) sich verjüngende Kanten aufweisen, die sich in einer ersten Richtung verjüngen, und/oder die zweite aktive Schicht (132) sich verjüngende Kanten aufweist, die sich in einer zweiten Richtung, die der ersten Richtung entgegengesetzt ist, verjüngen.

13. Dünnschichttransistor nach einem der vorhergehenden Ansprüche, der ferner Folgendes umfasst:
eine Pufferschicht (120) auf einem Substrat (110); und
eine Gate-Isolierschicht (140) auf der dritten aktiven Schicht (133) und der Pufferschicht (120).

14. Anzeigevorrichtung, die den Dünnschichttransistor nach einem der vorhergehenden Ansprüche umfasst.

15. Verfahren zum Herstellen eines Dünnschichttransistors, wobei das Verfahren Folgendes umfasst:
Bilden einer aktiven Schicht (130) auf einem Substrat (110);
Bilden einer Gate-Elektrode (150), die die aktive Schicht (130) zumindest teilweise überdeckt; und
Bilden eines ersten Verbindungsabschnitts (130a) und eines zweiten Verbindungsabschnitts (130b) durch selektives Leitendmachen von Bereichen der aktiven Schicht (130), die die Gate-Elektrode (150) nicht überdecken, um durch selektives Leitendmachen einen Kanalabschnitt (130n) zu bilden, wobei das Bilden der aktiven Schicht (130) Folgendes enthält:
Bilden einer ersten aktiven Schicht (131) auf dem Substrat (110);
Bilden einer zweiten aktiven Schicht (132) auf der ersten aktiven Schicht (131) in dem ersten Verbindungsabschnitt (130b) und dem zweiten Verbindungsabschnitt (130b) der aktiven Schicht (130); und
Bilden einer dritten aktiven Schicht (133), die die erste aktive Schicht (131) in dem Kanalabschnitt (130n) kontaktiert und die zweite aktive Schicht (132) in dem ersten Verbindungsabschnitt (130a) und dem zweiten Verbindungsabschnitt (130b) kontaktiert.

## Revendications

1. Transistor à couches minces (100) comportant :
une couche active (130) incluant une partie de canal (130n), une première partie de connexion (130a) et une seconde partie de connexion (130b) en contact avec des côtés opposés de la partie de canal (130n) ; et
une électrode de grille (150) chevauchant la partie de canal (130n) de la couche active (130), dans lequel la couche active (130) inclut :
une première couche active (131) ;
une deuxième couche active (132) sur la première couche active (131) dans la première partie de connexion (130a) et la seconde partie de connexion (130b) de la couche active (130) ; et
une troisième couche active (133) en contact avec la première couche active (131) dans la partie de canal (130n) et en contact avec la deuxième couche active (132) dans la première partie de connexion (130a) et la seconde partie de connexion (130b).

2. Transistor à couches minces selon la revendication 1, dans lequel la deuxième couche active (132) inclut une pluralité de motifs en forme d'îlots espacés (132a, 132b).

3. Transistor à couches minces selon la revendication 1 ou 2, dans lequel la première couche active (131) et la troisième couche active (133) sont en contact l'une avec l'autre dans une zone de la partie de canal (130n) ou la première couche active (131) et la troisième couche active (133) sont en contact l'une avec l'autre à une première frontière entre la partie de canal (130n) et la première partie de connexion (130a) et à une seconde frontière entre le canal et la seconde partie de connexion (130b).

4. Transistor à couches minces selon l'une quelconque des revendications précédentes, dans lequel une épaisseur de la couche active (130) est réduite le long d'une direction allant de la première partie de connexion (130a) vers la partie de canal (130n), de préférence à une frontière entre la partie de canal (130n) et la première partie de connexion (130a) et/ou une épaisseur de la couche active (130) est augmentée le long d'une direction allant de la partie de canal (130n) vers la seconde partie de connexion (130b), de préférence à une frontière entre la partie de canal (130n) et la seconde partie de connexion (130a).

5. Transistor à couches minces selon l'une quelconque des revendications précédentes, dans lequel la première couche active (131) et la troisième couche active (133) ne sont pas au contact l'une avec l'autre dans au moins une partie du canal.

6. Transistor à couches minces selon la revendication 5, dans lequel la deuxième couche active (132) est disposée entre la première couche active (131) et la troisième couche active (133) à une première frontière entre la partie de canal (130n) et la première partie de connexion (130a) et/ou la deuxième couche active (132) est disposée entre la première couche active (131) et la troisième couche active (133) à une seconde frontière entre la partie de canal (130n) et la seconde partie de connexion (130b).

7. Transistor à couches minces selon l'une quelconque des revendications précédentes, dans lequel la deuxième couche active (132) a une mobilité supérieure à une mobilité de la première couche active (131) et/ou la troisième couche active (133) a une mobilité supérieure à une mobilité de la première couche active (131) et/ou la troisième couche active (133) a une mobilité inférieure à une mobilité de la deuxième couche active (132).

8. Transistor à couches minces selon l'une quelconque des revendications précédentes, dans lequel la première couche active (131) inclut au moins un matériau parmi un matériau semi-conducteur d'oxyde à base d'IGZO (InGaZnO), un matériau semi-conducteur d'oxyde à base de GO (GaO), un matériau semi-conducteur d'oxyde à base de GZO (GaZnO), un matériau semi-conducteur d'oxyde à base d'IGO (InGaO) ou un matériau semi-conducteur d'oxyde à base de GZTO (GaZnSnO) et/ou lorsque le matériau semi-conducteur d'oxyde inclus dans la première couche active (131) inclut du gallium (Ga) et de l'indium (In), une concentration du gallium (Ga) est supérieure à celle de l'indium (In) sur la base du nombre de moles [concentration de Ga > concentration d'In].

9. Transistor à couches minces selon l'une quelconque des revendications précédentes, dans lequel la deuxième couche active (132) inclut au moins un matériau parmi un matériau semi-conducteur d'oxyde à base d'IGZO (InGaZnO), un matériau semi-conducteur d'oxyde à base d' IZO (InZnO), un matériau semi-conducteur d'oxyde à base d'ITZO (InSnZnO), un matériau semi-conducteur d'oxyde à base d'IGZTO (InGaZnSnO), un matérieur semi-conducteur d'oxyde à base de FIZO (FeInZnO), un matériau semi-conducteur d'oxyde à base de ZnO, un matériau semi-conducteur d'oxyde à base de SIZO (SiInZnO) ou un matériau semi-conducteur d'oxyde à base de ZnON (Zn-Oxynitrure) et/ou lorsque le matériau semi-conducteur d'oxyde inclus dans la deuxième couche active inclut du gallium (Ga) et de l'indium (In), une concentration de l'indium (In) est supérieure à celle du gallium (Ga) sur la base du nombre de moles [concentration de Ga < concentration d'In].

10. Transistor à couches minces selon l'une quelconque des revendications précédentes, dans lequel la troisième couche active (133) inclut au moins un matériau parmi un matériau semi-conducteur d'oxyde à base d'IGZO (InGaZnO), un matériau semi-conducteur d'oxyde à base d'IZO (InZnO), un matériau semi-conducteur d'oxyde à base d'ITZO (InSnZnO), un matériau semi-conducteur d'oxyde à base d'IGZTO (InGaZnSnO), un matériau semi-conducteur d'oxyde à base de FIZO (FeInZnO), un matériau semi-conducteur d'oxyde à base de ZnO, un matériau semi-conducteur d'oxyde à base de SIZO (SiInZnO) ou un matériau semi-conducteur d'oxyde à base de ZnON (Zn-Oxynitrure et/ou lorsque le matériau semi-conducteur d'oxyde inclus dans la troisième couche active inclut du gallium (Ga) et de l'indium (In), une concentration de l'indium (In) est supérieure à celle du gallium (Ga) sur la base du nombre de moles [concentration de Ga < concentration d'In].

11. Transistor à couches minces selon l'une quelconque des revendications 1 à 9 précédentes, dans lequel la troisième couche active (133) inclut au moins un matériau parmi un matériau semi-conducteur d'oxyde à base d'IGZO (InGaZnO), un matériau semi-conducteur d'oxyde à base de GO (GaO), un matériau semi-conducteur d'oxyde à base de GZO (GaZnO), un matériau semi-conducteur d'oxyde à base d'IGO (InGaO) ou un matériau semi-conducteur d'oxyde à base de GZTO (GaZnSnO) et/ou lorsque le matériau semi-conducteur d'oxyde inclus dans la troisième couche active inclut du gallium (Ga) et de l'indium (In), une concentration du gallium (Ga) est supérieure à celle de l'indium (In) sur la base du nombre de moles [concentration de Ga > concentration d'In].

12. Transistor à couches minces selon l'une quelconque des revendications précédentes, dans lequel une électrode parmi les électrodes de grille (G1, G2) ou les deux comportent des bords biseautés qui sont biseautés dans une première direction et/ou la deuxième couche active (132) comporte des bords biseautés qui sont biseautés dans une seconde direction opposée à la première direction.

13. Transistor à couches minces selon l'une quelconque des revendications précédentes, comportant en outre :
une couche tampon (120) sur un substrat (110) ; et
une couche d'isolation de grille (140) sur la troisième couche active (133) et la couche tampon (120).

14. Appareil d'affichage comportant le transistor à couches minces de l'une quelconque des revendications précédentes.

15. Procédé de fabrication d'un transistor à couches minces, le procédé comportant les étapes consistant à :
former une couche active (130) sur un substrat (110) ;
former une électrode de grille (140) chevauchant au moins partiellement la couche active (130) ; et
former une première partie de connexion (130a) et une seconde partie de connexion (130b) en induisant sélectivement une conductivité des zones de la couche active (130) ne chevauchant pas l'électrode de grille (150) pour former une partie de canal (130n) par l'induction sélective d'une conductivité, dans lequel la formation de la couche active (130) inclut de :
former une première couche active (131) sur le substrat (110) ;
former une deuxième couche active (132) sur la première couche active (131) dans la première partie de connexion (130a) et la seconde partie de connexion (130b) de la couche active (130) ; et
former une troisième couche active (133) en contact avec la première couche active (131) dans la partie de canal (130n) et en contact avec la deuxième couche active (132) dans la première partie de connexion (130a) et la seconde partie de connexion (130b).
